(19) Europäisches Patentamt / European Patent Office / Office européen des brevets

(11) **EP 3 089 550 A1**

(12) **EUROPEAN PATENT APPLICATION**
published in accordance with Art. 153(4) EPC

(43) Date of publication:
**02.11.2016 Bulletin 2016/44**

(21) Application number: **14875433.6**

(22) Date of filing: **26.11.2014**

(51) Int Cl.:
$H05B\ 33/02$ (2006.01)　　　$H01L\ 51/50$ (2006.01)
$H05B\ 33/22$ (2006.01)

(86) International application number:
**PCT/JP2014/081182**

(87) International publication number:
**WO 2015/098401 (02.07.2015 Gazette 2015/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **27.12.2013　JP 2013272344**

(71) Applicant: **JX Nippon Oil & Energy Corporation**
**Chiyoda-ku**
**Tokyo 100-8162 (JP)**

(72) Inventors:
• **NISHIMURA, Suzushi**
  **Tokyo 100-8162 (JP)**
• **SHIBANUMA, Toshihiko**
  **Tokyo 100-8162 (JP)**
• **TORIYAMA, Shigetaka**
  **Tokyo 100-8162 (JP)**

(74) Representative: **Kuhnen & Wacker**
**Patent- und Rechtsanwaltsbüro**
**Prinz-Ludwig-Straße 40A**
**85354 Freising (DE)**

(54) **LIGHT-EMITTING ELEMENT**

(57)　A light emitting element 100 includes: a concave-convex structure layer 142, a first electrode 92, an organic layer 94, and a second electrode layer 98 which are provided on a surface of a base member 40 in this order; and a lens member 20 arranged on an opposite surface of the base member 40 on a side opposite to the surface, wherein a center of the lens member and a center of a light emitting portion 94a are coincident to each other in a plane view, the light emitting portion 94a being an area of the organic layer sandwiched between the first and second electrodes in a thickness direction of the base member; a ratio of a diameter D2 of the light emitting portion to a diameter D1 of the lens member satisfies $D2/D1 \leq 0.7$; and a ratio of a distance d to the diameter D1 of the lens member satisfies $d/D1 \leq 0.25$, the distance d being a distance between the opposite surface of the base member and the center of the light emitting portion. This provides a light emitting element which has a sufficient light-emitting efficiency and in which the chromaticity angle dependency is small.

**Fig. 1**

(a)

(b)

EP 3 089 550 A1

## Description

TECHNICAL FIELD

The present invention relates to a light emitting element usable in a display, an illumination device, etc.

BACKGROUND ART

Light emitting elements expected as next-generation of displays or illumination devices include an organic light emitting diode referred to as an organic EL element (organic Electro-Luminescence element). In an organic EL element, a hole injected from a hole injecting layer and electron injected from an electron injecting layer are each carried to a light emitting layer, then the hole and electron are recombined on an organic molecule in the light emitting layer to excite the organic molecule, thereby generating light emission or radiation. Therefore, in order that the organic EL element is used as the display device or the illumination device, the light from the light emitting layer is required to be efficiently extracted from the surface of the organic EL element. For this purpose, a configuration wherein a semispherical lens is provided on an organic EL element is known by Patent Literature 1.

[Citation List]

[Patent Literature]

   PATENT LITERATURE 1: Japanese Patent Application Laid-open No. 2011-054407
   PATENT LITERATURE 2: PCT International Publication No. WO2012/147759

SUMMARY OF INVENTION

Problem to be Solved by the Invention:

However, as described in Patent Literature 2 by the Applicant of the present application, such a light emitting element provided with the semispherical lens is found to have a problem that the angle dependency of chromaticity (chromaticity angle dependency; the change in color due to the field angle) is great in the light emitting element. In order that the organic EL element can be practically used in a wide variety of applications including displays, illumination, etc., the organic EL element is required to have a low chromaticity angle dependency while having a sufficient light emission efficiency (luminous efficacy), and there is a demand to develop such an organic EL element.

In view of the above situations, an object of the present invention it to provide a light emitting element having a sufficient light emission efficiency, as well as a small change in the color due to the field angle.

Solution to the Problem:

According to an aspect of the present invention, there is provided a light emitting element, including:

   a concave-convex structure layer, a first electrode, an organic layer, and a second electrode which are provided on a surface of a base member in this order; and
   a lens member arranged on an opposite surface of the base member on a side opposite to the surface,

wherein a center of the lens member and a center of a light emitting portion are coincident to each other in a plane view, the light emitting portion being an area of the organic layer sandwiched between the first and second electrodes in a thickness direction of the base member;
a ratio of a diameter D2 of the light emitting portion to a diameter D1 of the lens member satisfies $D2/D1 \leq 0.7$; and
a ratio of a distance d to the diameter D1 of the lens member satisfies $d/D1 \leq 0.25$, the distance d being a distance between the opposite surface of the base member and the center of the light emitting portion.

In the light emitting element, the lens member may be a semispherical lens.

In the light emitting element, the concave-convex structure layer may be formed of a sol-gel material.

The light emitting element may include a covering layer covering a surface of the concave-convex structure layer and arranged between the concave-convex structure layer and the first electrode.

In the light emitting element, the base member may be a glass base member.

In the light emitting element, refractive index of the lens member may be not less than 1.4.

In the light emitting element, the concave-convex structure layer may have a concave-convex pattern in which an average pitch of concavities and convexities is in a range of 100 nm to 1500 nm, and a standard deviation of depth of the concavities and convexities is in a range of 10 nm to 100 nm.

In the light emitting element, the diameter D1 of the lens member may be in a range of 1 mm to 100 mm; the diameter D2 of the light emitting portion may be in a range of 0.5 mm to 70 mm; and the distance d between the opposite surface of the base member and the center of the light emitting portion may be in a range of 0.04 mm to 5 mm.

EFFECT OF INVENTION

The light emitting element of the present invention is provided with the lens member and the concave-convex structure layer, wherein the ratio r1 of the diameter of the light emitting portion to the diameter of the lens member satisfies $r1 \leq 0.7$; and the ratio r2 of the distance between the surface of the base member having the lens member arranged thereon and the center of the light emitting portion to the diameter of the lens member satisfies $r2 \leq 0.25$. With this, the light emitting element of the present invention is capable of efficiently extracting the light, emitted in the light emitting portion, to the outside thereof, and thus the light emitting element has a high light emitting efficiency (current efficiency). Further, in the light emitting element of the present invention, the change in color due to the field angle (chromaticity angle dependency) is small. Accordingly, the light emitting element of the present invention is quite effective for a variety of kinds of light emitting devices such as displays, illumination devices, etc.

BRIEF DESCRIPTION OF DRAWINGS

Figs. 1(a) and 1(b) schematically depict a light emitting element according to an embodiment of the present invention, wherein Fig. 1(a) is a schematic top view and Fig. 1(b) is a schematic cross-sectional view as viewed in a I-I direction of Fig. 1(a).

Figs. 2(a) and 2(b) schematically depict a light emitting element according to another embodiment of the present invention, wherein Fig. 2(a) is a schematic top view and Fig. 2(b) is a schematic cross-sectional view as viewed in a I-I direction of Fig. 2(a).

Fig. 3 conceptually depicts an exemplary transfer step in a manufacturing method for manufacturing the light emitting element of the embodiment.

Fig. 4 is a schematic cross-sectional view of a light emitting element of each of Comparative Examples 1, 4, 6, 8, 11, 13, 15, 18 and 21.

Fig. 5 is a schematic cross-sectional view of a light emitting element of each of Comparative Examples 2, 5, 7, 9, 12, 14, 16, 19 and 22.

Fig. 6 is a table showing the results of evaluation of chromaticity angle dependency in light emitting elements in Example 1 and Comparative Examples 1 to 3.

Fig. 7 is a table showing the results of evaluation of current efficiency in light emitting elements in Examples 2 to 6 and Comparative Examples 4 to 22.

Figs. 8(a) and 8(b) schematically depict a light emitting element according to still another embodiment of the present invention and having an adhesive layer directly formed on a base member, wherein Fig. 8(a) is a schematic top view and Fig. 8(b) is a schematic cross-sectional view as viewed in a I-I direction of Fig. 8(a).

Figs. 9(a) and 9(b) schematically depict a light emitting element according to yet another embodiment of the present invention and having an adhesive layer contacting both of a concave-convex structure layer and a base member, wherein Fig. 9(a) is a schematic top view and Fig. 9(b) is a schematic cross-sectional view as viewed in a I-I direction of Fig. 9(a).

DESCRIPTION OF EMBODIMENTS

In the following, an embodiment of a light emitting element (optical element) and a method for manufacturing the light emitting element according to the present invention will be explained with reference to the drawings.

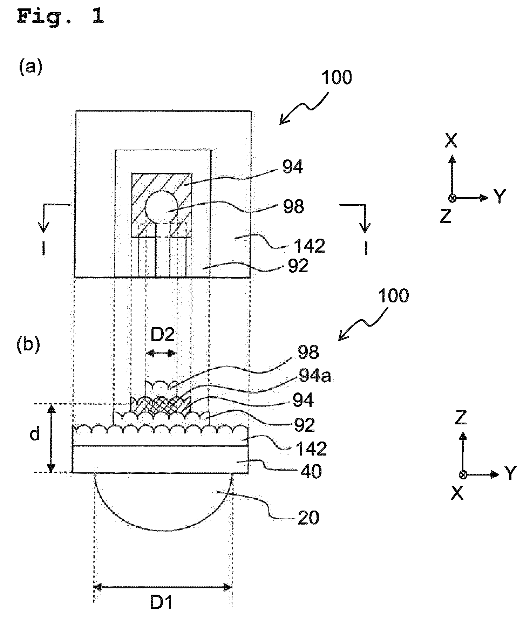

The schematic top view and schematic cross-sectional view of a light emitting element 100 of the embodiment are depicted respectively in Figs. 1(a) and 1(b). The light emitting element 100 mainly includes a plate-shaped base member 40, a concave-convex structure layer 142, a first electrode 92, an organic layer 94, a second electrode 98 and a lens member 20. The concave-convex structure layer 142, the first electrode 92, the organic layer 94 and the second electrode 98 are formed in this order on one surface of the base member, and the lens member 20 is arranged on the other surface (opposite surface), of the base member, opposite to the one surface.

As depicted in Figs. 1(a) and 1(b), provided that an in-plain direction of the base member 40 is defined as an XY direction, and a direction perpendicular to the XY direction, namely, a height direction of the light emitting element 100 (thickness direction of the base member) is defined as a Z direction, an area in the organic layer 94 which is sandwiched between the first electrode 92 and the second electrode 98 in the Z direction (a hatched portion in Fig. 1(b)) becomes a portion which emits light under a condition that the light emitting element is electrified or energized, namely becomes a light emitting portion 94a. In the light emitting element 100, the light emitting portion 94a and the lens member 20 are arranged such that the centers of the light emitting portion 94a and the lens member 20 are coincident to each other in a plane view. The term "the centers ... are coincident to each other in a plane view" means that when the light emitting element 100 is viewed from a direction parallel to the optical axis of the lens member 20 (Z direction), one piece of the light emitting portion 94a is overlapped only with one piece of the lens member 20 and the position of the optical axis of the lens member 20 is substantially coincident with the position of the center of the light emitting portion 94a in the in-plane (XY) direction.

As depicted in Figs. 1(a) and 1(b), provided that the diameter of the lens member 20 is defined as "D1", the dimeter of the light emitting portion 94a is defined as "D2", and the distance in the Z direction between the surface of the base member 40 on which the lens member 20 is arranged (an adhesion surface of the base member 40 at which the lens member 20 is adhered to the base member 40) and the center of the light emitting portion 94a in the Z direction is defined as "d", then in the light emitting element 100 of the present embodiment, a ratio r1 of D2 to D1 satisfies $r1 \leq 0.7$ and a ratio r2 of d to D1 satisfies $r2 \leq 0.25$. In a case that the ratio r1 and the ratio r2 both exceed the upper limit values thereof, respectively, the efficiency of extracting the light emitted in the light emitting portion 94a therefrom is lowered and the light emission efficiency (current efficiency) of the light emitting element becomes insufficient in some cases, as appreciated from examples and comparative examples (to be described later on). From the viewpoint of improving the light extracting efficiency by the lens member, the values of the ratio r1 and the ratio r2 preferably become closer to 0 (zero) as much as possible. Therefore, it is preferred that the ratio r1 and the ratio r2 are respectively within a range of $0 < r1 \leq 0.7$ and a range of $0 < r2 \leq 0.25$. On the other hand, as will be described later on, in view of the handleability (ease of handling) and the mechanical strength, etc., the diameter D1 is preferably within a range of 1 mm to 100 mm and the diameter D2 is preferably within a range of 0.5 mm to 70 mm. Further, as will be described later on, since the thickness of the base member 40 is preferably in a range of 40 $\mu$m to 3000 $\mu$m, the distance d is preferably in a range of 0.04 mm to 5 mm.

<Base member>

The base member 40 is not particularly limited, and it is possible to appropriately use any publicly known transparent substrate which can be used for the light emitting element. Those usable as the base member 40 include, for example, a substrate made of a transparent inorganic material such as glass; substrates made of resins such as polyester (polyethylene terephthalate, polybutylene terephthalate, polyethylene naphthalate, polyarylate, and the like), an acrylic-based resin (polymethyl methacrylate and the like), polycarbonate, polyvinyl chloride, a styrene-based resin (ABS resin and the like), a cellulose-based resin (triacetyl cellulose and the like), a polyimide-based resin (polyimide resin, polyimideamide resin, and the like) and cycloolefin polymer; a stacked substrate obtained by forming, on the surface of a substrate made of any one of the foregoing resins, a gas barrier layer made of an inorganic material such as SiN, $SiO_2$, SiC, $SiO_xN_y$, $TiO_2$, or $Al_2O_3$ and/or a gas barrier layer made of a resin material; and a stacked substrate obtained by alternately stacking, on a substrate made of any one of the foregoing resins, the gas barrier layer made of the inorganic material and the gas barrier layer made of the resin material. In terms of uses (application purpose) of the light emitting element, the base member 40 desirably has the heat resistance and the weather resistance to UV light and the like. In view of these points, thus, base members made of inorganic materials such as glass and quarts substrates are more preferably used. In particular, in a case that the base member 40 is made of the inorganic material and that the concave-convex structure layer 142 is made of an inorganic material such as a sol-gel material, then the difference between the refractive index of the base member 40 and the refractive index of the concave-convex structure layer 142 is small, which in turn makes it possible to prevent any unintended refraction and/or reflection in the light emitting element 100. Thus, the base member 40 is preferably made of any inorganic material. It is allowable to perform a surface treatment for the base member 40 or to provide an easy-adhesion layer on the base member 40 so as to improve the adhesion property of the base member 40; and/or it is also allowable to provide a gas barrier layer in order to keep out moisture and/or gas such as oxygen. The thickness of the base member 40 is preferably to be thin in order to improve the light extracting efficiency, and is preferably within a range of 40 $\mu$m to 3000 $\mu$m. In a case that the thickness of the base member 40 is less than the lower limit as described above, the handling of the base member 40 becomes difficult in some cases, and a base member with such a thickness is hard to obtain.

<Concave-Convex Structure Layer>

The concave-convex structure layer 142 is a layer having a minute concave-convex pattern formed on a surface thereof. The minute concave-convex pattern may be any pattern such as a lens structure or a structure having the light diffusion function, light diffraction function, etc. Among the above-described concave-convex patterns, an irregular concave-convex pattern in which pitches of concavities and convexities are non-uniform and orientations of concavities and convexities have no directionality. In order that the concave-convex structure layer 142 functions as the diffraction grating, the average pitch of concavities and convexities is preferably in a range of 100 nm to 1500 nm. In a case that the average pitch of concavities and convexities is less than the lower limit, pitches are so small relative to the wavelengths of the visible light that the diffraction of the light by concavities and convexities is less likely to occur. On the other hand, in a case that the average pitch exceeds the upper limit, the diffraction angle is so small that functions as the diffraction grating are more likely to be lost. The average pitch of concavities and convexities is more preferably in a range of 200 nm to 1200 nm. The average value of the depth distribution of concavities and convexities is preferably in a range of 20 nm to 200 nm. In a case that the average value of the depth distribution of concavities and convexities is less than the lower limit, the depth is so small relative to the wavelengths of the visible light that the required diffraction is less likely to occur. On the other hand, in a case that the average value exceeds the upper limit, the intensity of diffracted light becomes non-uniform, which in turn results in the following tendency. Namely, for example, the electric field distribution in the organic layer 94 of the light emitting element 100 becomes non-uniform, thereby causing the electric field to concentrate on a certain position or area in the organic layer 94 and thus causing any leak current to be easily generated, and/or shortening the service life of the light emitting element 100. The average value of the depth distribution of concavities and convexities is more preferably in a range of 30 nm to 150 nm. The standard deviation of the depth of convexities and concavities is preferably in a range of 10 nm to 100 nm. In a case that the standard deviation of depth of convexities and concavities is less than the lower limit, the depth is so small relative to the wavelengths of the visible light that the required diffraction is less likely to occur. On the other hand, in a case that the standard deviation exceeds the upper limit, the intensity of diffracted light becomes non-uniform, which in turn results in the following tendency. Namely, for example, the electric field distribution in the organic layer 94 of the light emitting element 100 becomes non-uniform, thereby causing the electric field to concentrate on a certain position or area in the organic layer 94 and thus causing any leak current to be easily generated, and/or shortening the service life of the light emitting element 100. The standard deviation of depth of convexities and concavities is preferably within a range of 15 nm to 75 nm.

Note that the term "average pitch of concavities and convexities" in the present application means an average value of the pitch of concavities and convexities in a case of measuring the pitch of concavities and convexities (spacing distance between adjacent convex portions or spacing distance between adjacent concave portions) in a surface on which the convexities and concavities are formed. Such an average value of the pitch of concavities and convexities is obtained as follows. Namely, a concavity and convexity analysis image is obtained by measuring the shape of concavities and convexities on the surface by using a scanning probe microscope (for example, a scanning probe microscope manufactured by HITACHI HIGH-TECH SCIENCE CORPORATION, under the product name of "E-sweep", etc.), under the following measurement conditions, then the distances between randomly selected concave portions or convex portions adjacent to each other are measured at not less than 100 points in the concavity and convexity analysis image, and then the average of the distances is calculated and is determined as the average value of the pitch of concavities and convexities. The measurement conditions are as follows:

Measurement mode: cantilever intermittent contact mode
Material of the cantilever: silicon
Lever width of the cantilever: 40 $\mu$m
Diameter of tip of chip of the cantilever: 10 nm

Further, in the present application, the average value of the depth distribution of concavities and convexities and the standard deviation of the depth of concavities and convexities can be calculated by the following manner. Namely, a concavity and convexity analysis image is obtained by measuring the shape of concavities and convexities on the surface by using a scanning probe microscope (for example, a scanning probe microscope manufactured by HITACHI HIGH-TECH SCIENCE CORPORATION, under the product name of "E-sweep", etc.), in a randomly selected measurement region of 3 $\mu$m square (vertical: 3 $\mu$m, horizontal: 3 $\mu$m) or in a randomly selected measurement region of 10 $\mu$m square (vertical: 10 $\mu$m, horizontal: 10 $\mu$m) under the above-described conditions. When doing so, data of height of concavities and convexities at not less than 16,384 points (vertical: 128 points x horizontal: 128 points) are obtained within the measurement region, each in nanometer scale. Note that although the number of measurement points is different depending on the kind and setting of the measuring device which is used, for example in a case of using the above-described scanning probe microscope manufactured by HITACHI HIGH-TECH SCIENCE CORPORATION, under the product name of "E-sweep", it is possible to perform the measurement at measurement points of 65,536 points (vertical: 256 points x horizontal: 256 points; namely, the measurement in a resolution of 256 x 256 pixels) within the measurement region of 10 μm square. With respect to the height of concavities and convexities (unit: nm) measured in such a manner, at first, a measurement point "P" is determined, among all the measurement points, which is the highest from the surface of a base member. Then, a plane which includes the measurement point P and which is parallel to the surface of the base member is determined as a reference plane (horizontal plane), and a depth value from the reference plane (difference obtained by subtracting, from the value of height from the base member at the measurement point P, the height from the base member at each of the measurement points) is obtained as the data of depth of concavities and convexities. Note that such a depth data of concavities and convexities can be obtained, for example, by performing automatic calculation with software in the measurement device (for example, the above-described scanning probe microscope manufactured by HITACHI HIGH-TECH SCIENCE CORPORATION, under the product name of "E-sweep"), and the value obtained by the automatic calculation in such a manner can be utilized as the data of depth of concavities and convexities. After obtaining the data of depth of concavity and convexity at each of the measurement points in this manner, the values, which can be calculated by obtaining the arithmetic average value and the standard deviation of the obtained data of depth of concavity and convexity, are adopted as the average value of the depth distribution of concavities and convexities and the standard deviation of the depth of concavities and convexities. In this specification, the average pitch of concavities and convexities and the average value of the depth distribution of concavities and convexities can be obtained via the above-described measuring method, regardless of the material of the surface on which concavities and convexities are formed.

Note that, however, the term "irregular concave-convex pattern" includes such a quasi-periodic structure in which a Fourier-transformed image, obtained by performing a two-dimensional fast Fourier-transform processing on a concavity and convexity analysis image obtained by analyzing a concave-convex shape on the surface, shows a circular or annular pattern, namely, such a quasi-periodic structure in which, although concavities and convexities have no particular orientation (directionality), the structure has the distribution of pitches of concavities and convexities (pitches of concavities and convexities vary). Therefore, the substrate having such a quasi-periodic structure is suitable for a diffraction substrate used in a surface-emitting element, such as the organic EL element, provided that the substrate has concavities and convexities of which pitch distribution or pitch variability enables the substrate to diffract visible light.

As the material of the concave-convex structure layer 142, inorganic materials may be used. In particular, it is allowable to use sol-gel materials such as silica, titanium-based materials ($TiO_2$ and the like), materials based on indium-tin oxide (ITO), and ZnO, $ZrO_2$, $Al_2O_3$, ZnS, $BaTiO_3$, and $SrTiO_2$. Among the above-described materials, silica or $TiO_2$ is preferably used in view of the film formation performance (coating property) and the refractive index. Further, cured resin compositions may be used as the material of the concave-convex structure layer 142. Examples of the resin compositions may include photo-curable resins and thermo-curable resins having a reactive vinyl group such as acrylic acid-based oligomer and methacrylic acid-based oligomer; moisture curing type resins such as 2-cyanoacylic acid ester; thermo-curable and chemical curing type resins (two-liquid mixing type resins) such as epoxy-based resin; hot-melt resins such as polyamide, polyester, and polyolefin; and ultraviolet curable epoxy resins of cation curable type. Examples of the resin compositions may further include various resins such as monomers, oligomers, polymers, etc., of those based on vinyl ether, oxetane, urethane, melamine, urea, phenol, cross-linking type liquid crystal, fluorine, silicone, etc. Further, as the material of the concave-convex structure layer 142, it is possible to use $SiO_x$, $SiN_x$, $SiO_xN_y$, and the like which are formed by using a polysilazane solution as raw material.

The thickness of the concave-convex structure layer 142 is preferably in a range of 100 nm to 10 μm. In a case that the thickness of the concave-convex structure layer 142 is less than 100 nm, the transfer of the concave-convex shape by imprinting as described later is difficult. In a case that the thickness of the concave-convex structure layer 142 exceeds 10 μm, any structural defect such as a crack is more likely to occur. The thickness of the concave-convex structure layer 142 in this context means an average value of distances from the bottom surface of the concave-convex structure layer 142 to the surface in which the concave-convex pattern is formed.

In a case that the adhesive force between the base member 40 and the concave-convex structure layer 142 is weak, an adhesion layer may be provided between the base member 40 and the concave-convex structure layer 142. The adhesion layer may be made of a silane coupling agent or the like. Those usable as the silane coupling agent include, for example, agents having an acrylic group and agents having a methacryl group such as KBM-5103 (produced by SHIN-ETSU CHEMICAL, CO., LTD.) and KBM-503 (produced by SHIN-ETSU CHEMICAL, CO., LTD.).

<First Electrode>

The first electrode 92 may be a transparent electrode so that the light from the organic layer 94 formed on the first electrode 92 passes toward the base member 40. It is preferred that the first electrode 92 be stacked such that the surface of the first electrode 92 maintains or shows the concave-convex structure formed in the surface of the concave-convex structure layer 142. Note that the arrangement and the shape of the first electrode 92 in the XY direction are not particularly limited.

Those usable as the material of the first electrode 92 include, for example, indium oxide, zinc oxide, tin oxide, indium-tin oxide (ITO) which is a composite material thereof, gold, platinum, silver, and copper. Among these materials, ITO is preferable from the viewpoint of transparency and electrical conductivity. The thickness of the first electrode 92 is preferably within a range of 20 nm to 500 nm.

<Organic Layer>

The organic layer 94 is formed on the first electrode 92. However, as depicted in Fig. 1(a), the organic layer 94 may be formed on the concave-convex structure layer 142 at a location or portion of the base member 40 (the light emitting element 100) at which the first electrode 92 is not formed. The organic layer 94 is not particularly limited, provided that the organic layer 94 is usable as an organic layer of the organic EL element. As the organic layer 94, any publicly known organic layer can be used as appropriate. The surface of the organic layer 94 may maintain the shape of the concave-convex structure layer 142 or may be flat without maintaining the shape of the concave-convex structure layer 142. The organic layer 94 may be a stacked body of various organic thin films. For example, the organic layer 94 may be a stacked body of a hole transporting layer, a light-emitting layer, and an electron transporting layer. Those usable as the material of the hole transporting layer include, for example, aromatic diamine compounds such as phthalocyanine derivatives, naphthalocyanine derivatives, porphyrin derivatives, N,N'-bis(3-methylphenyl)-(1,1'-biphenyl)-4,4'-diamine (TPD), and 4,4'-bis[N-(naphthyl)-N-phenyl-amino]biphenyl($\alpha$-NPD); oxazole; oxadiazole; triazole; imidazole; imidazolone; stilbene derivatives; pyrazoline derivatives; tetrahydroimidazole; polyarylalkane; butadiene; and 4,4',4"-tris(N-(3-methylphenyl)N-phenylamino)triphenylamine (m-MTDATA). The examples of materials of the hole transporting layer, however, are not limited to the above-described materials. The light emitting layer is provided in order that a hole injected from the first electrode 92 and an electron injected from the second electrode 98 are recombined to occur light emission. Those usable as the material of the light emitting layer include, for example, metallo-organic complex such as anthracene, naphthalene, pyrene, tetracene, coronene, perylene, phthaloperylene, naphthaloperylene, diphenylbutadiene, tetraphenylbutadiene, coumarin, oxadiazole, bisbenzoxazoline, bisstyryl, cyclopentadiene, and aluminum-quinolinol complex (Alq3); tri-(p-terphenyl-4-yl)amine; 1-aryl-2,5-di(2-thienyl) pyrrole derivatives; pyran; quinacridone; rubren; distyrylbenzene derivatives; distyryl arylene derivatives; distyryl amine derivatives; and various fluorescent pigments or dyes. Further, it is preferred that light-emitting materials selected from the above compounds be mixed as appropriate and then used. Furthermore, it is possible to preferably use a material system generating emission of light from a spin multiplet, such as a phosphorescence emitting material generating emission of phosphorescence and a compound including, in a part of the molecules, a constituent portion formed by the above materials. The phosphorescence emitting material preferably includes heavy metal such as iridium. A host material having high carrier mobility may be doped with each of the light-emitting materials as a guest material to generate the light emission using dipole-dipole interaction (Forster mechanism) or electron exchange interaction (Dexter mechanism). Those usable as the material of the electron transporting layer include, for example, heterocyclic tetracarboxylic anhydrides such as nitro-substituted fluorene derivatives, diphenylquinone derivatives, thiopyran dioxide derivatives, and naphthaleneperylene; and metallo-organic complex such as carbodiimide, fluorenylidene methane derivatives, anthraquino dimethane and anthrone derivatives, oxadiazole derivatives, and aluminum-quinolinol complex (Alq3). Further, in the oxadiazole derivatives mentioned above, it is also possible to use, as an electron transporting material, thiadiazole derivatives in which oxygen atoms of oxadiazole rings are substituted by sulfur atoms and quinoxaline derivatives having quinoxaline rings known as electron attractive group. Furthermore, it is also possible to use a polymeric material in which the above materials are introduced into a macromolecular chain or the above materials are made to be a main chain of the macromolecule. Note that the hole transporting layer or the electron transporting layer may also function as the light-emitting layer.

From the viewpoint of facilitating the electron injection from the second electrode 98, a layer made of a metal fluoride or metal oxide such as lithium fluoride (LiF) or $Li_2O_3$, a highly active alkaline earth metal such as Ca, Ba, or Cs, an organic insulating material, or the like may be provided as an electron injection layer between the organic layer 94 and the second electrode 98. Further, from the viewpoint of facilitating the hole injection from the first electrode 92, it is allowable to provide, as a hole injection layer between the organic layer 94 and the first electrode 92, a layer made of triazol derivatives, oxadiazole derivative, imidazole derivative, polyarylalkane derivatives, pyrazoline and pyrazolone derivatives, phenylenediamine derivative, arylamine derivatives, amino-substituted calcone derivatives, oxazole derivatives, styrylanthracene derivatives, fluorenone derivatives, hydrazone derivatives, stilbene derivatives, silazane derivatives, aniline-based copolymers, or electroconductive high-molecular oligomar, particularly thiophene oligomer.

Furthermore, in a case that the organic layer 94 is a stacked body formed of the hole transporting layer, the light emitting layer, and the electron transporting layer, the thicknesses of the hole transporting layer, the light emitting layer, and the electron transporting layer are preferably within a range of 1 nm to 200 nm, a range of 5 nm to 100 nm, and a range of 5 nm to 200 nm, respectively.

In the organic layer 94, an area or region, which is sandwiched by the first electrode 92 and the second electrode 98 (to be described later on) in the Z direction becomes a light emitting portion 94a. Although the shape of the light emitting portion 94a is not particularly limited, the light emitting portion 94a may be circular-shaped, oval-shaped (elliptic) or polygonal-shaped. Note that in the embodiment, in a case that the light emitting portion 94a is elliptic, the major axis of the light emitting portion 94a is defined as the diameter D2 of the light emitting portion (light emitting portion-diameter D2); in a case that the light emitting portion 94a is polygonal-shaped, the length of the longest diagonal line among the diagonal lines in the light emitting portion 94a is defined as the light emitting portion-diameter D2. The light emitting portion-diameter D2 is preferably within a range of 0.5 nm to 70 nm. Forming a light emitting portion 94a having the diameter D2 less than the lower limit of the above range is difficult, since a high patterning technique is required. On the other hand, in a case that the light emitting portion-diameter D2 exceeds the upper limit of the above range, it is difficult, in some cases, to stack thin films constructing the organic EL element uniformly in (on) the whole area of the light emitting portion 94a. Note that the value of the light emitting portion-diameter D2 may be appropriately changed based on the value of the diameter D1 of the lens member 20 (lens diameter D1).

<Second electrode>

The second electrode 98 is formed on the organic layer 94. It is allowable, however, that the second electrode 98 is formed partially on the concave-convex structure layer 142 at a portion at which the organic layer 94 is not formed, as depicted in Fig. 1(a). As the material of the second electrode 98, a substance having a small work function can be used as appropriate, although the material of the second electrode 98 is not particularly limited to this. For example, the second electrode 98 may be a metal electrode using aluminum, MgAg, MgIn, AlLi, or the like. The thickness of the second electrode 98 is preferably in a range of 50 nm to 500 nm. The second electrode 98 may be stacked such that the surface of the second electrode 98 maintains or shows the concave-convex structure formed in the surface of the concave-convex structure layer 142.

<Lens Member>

The lens member 20 is used to extract, efficiently to the outside of the base member 40, such a light that is repeatedly reflected inside the base member 40. As such a lens member 20, any member is suitable provided that the member is usable for extracting light in the organic EL element, and is not particularly limited. It is allowable to use any publicly known optical member having a configuration capable of extracting the light to the outside of the element. It is allowable to use, as such a lens member 20, for example, a convex lens (semispherical lens, an elliptic lens, etc.), a concave lens, a Fresnel lens, etc. Note that any commercially available product may be used as the lens member 20 configured to extract light to the outside, as described above. Note that in a case that an elliptic lens is used as the lens member, the major axis of the elliptic lens member is defined as the lens diameter D1; in a case that a polygonal-shaped lens is used as the lens member, the length of the longest diagonal line among the diagonal lines (the maximum value among the values of the lengths of the diagonal lines) in the polygonal-shaped lens is defined as the lens diameter D1. The lens diameter D1 is preferably in a range of 1 mm to 100 mm. In a case that the lens diameter D1 is less than the lower limit of the above range, it is difficult to performing the positioning such that the center of the lens member 20 and the center of the light emitting portion 94a are coincident to each other in the plane view; on the other hand, in a case that the lens diameter D1 exceeds the upper limit of the above range, the thickness of the light emitting element as a whole becomes great, which in turn lowers the design (designability) when the light emitting element is used as a display or an illumination device.

As the lens member 20 for extracting the light to the outside, those having various sizes and shapes can be used depending on the use, the size, the structure, and the like of the optical element. In addition, in a case that the thickness of the organic EL element is not an important issue (in a case that the thickness of the organic EL element may be great), it is preferred that a semispherical lens is used; on the other hand, in a case that the thickness of the organic EL element is an important issue (in a case that a thin organic EL element is more preferred), it is preferred that a Fresnel lens is used.

The material of such a lens member 20 is not particularly limited, and a lens member made of a publicly known material can be used. It is possible to use, for example, transparent inorganic materials such as glass and transparent resin materials made of transparent polymers, etc., including polyester-based resin such as polyethylene terephthalate and the like, cellulose-based resin, acetate-based resin, polyethersulfone-based resin, polycarbonate-based resin, polyamide-based resin, polyimide-based resin, polyolefin-based resin, and acrylic-based resin. The lens member 20 is preferably formed of a material of which refractive index is greater than the refractive index of the base member 40, more preferably a material of which refractive index at a wavelength of 589 nm is not less than 1.4, further more preferably a material of which refractive index at the wavelength of 589 nm is in a range of 1.5 to 2.0. Further, in order to suppress the reflection at the interface between the base member 40 and the lens member 20, it is preferred that the lens member 20 be stacked on the base member 40 via a pressure-sensitive adhesive layer and/or an adhesive layer to prevent air from being sandwiched between the base member 40 and the lens member 20.

Regarding the lens member 20 as described above, a protective layer may be stacked on the surface of the lens member 20 from the viewpoint of improving the wear resistance and scratch resistance of the surface thereof. It is possible to use a transparent film or a transparent inorganic deposited layer as the protective layer. The transparent film is not particularly limited, and a publicly known transparent film can be used. Examples of the transparent film include films made of transparent polymers such as polyester-based resin including polyethylene terephthalate and the like, cellulose-based resin, acetate-based resin, polyethersulfone-based resin, polycarbonate-based resin, polyamide-based resin, polyimide-based resin, polyolefin-based resin, and acylic-based resin. Further, the transparent film may be used as follows. Namely, the pressure-sensitive adhesive layer or the adhesive layer is formed on one surface of the transparent film, and the transparent film with the pressure-sensitive adhesive layer or the adhesive layer is adhered onto the surface of the optical member. As the pressure-sensitive adhesive or the adhesive agent, it is possible to appropriately use, for example, acrylic-based pressure-sensitive adhesive; ethylene-vinyl acetate copolymer; natural rubber-based pressure-sensitive adhesive, synthetic rubber-based pressure-sensitive adhesive such as polyisobutylene, butyl rubber, styrene-butylene-styrene copolymer, and styrene-isoprene-styrene block copolymer; polyurethane-based pressure-sensitive adhesive; and polyester-based pressure-sensitive adhesive.

In a case that the inorganic deposited layer is stacked as the protective layer, it is possible to appropriately use a publicly known metallic material which can form a transparent inorganic layer by the evaporation method. Examples of the material of the inorganic layer include oxide, nitride and sulfide of metal such as Sn, In, Te, Ti, Fe, Co, Zn, Ge, Pb, Cd, Bi, Se, Ga, and Rb. From the viewpoint of sufficiently preventing the deterioration caused by oxidation, it is possible to use $TiO_2$ suitably as the material of the inorganic layer. From the viewpoint of obtaining high luminance at a low cost, it is possible to use ZnS suitably as the material of the inorganic layer. The method for forming the inorganic deposited layer is not particularly limited, and it is possible to manufacture the inorganic deposited layer by using any publicly known physical vapor deposition equipment as appropriate.

<Sealing Member>

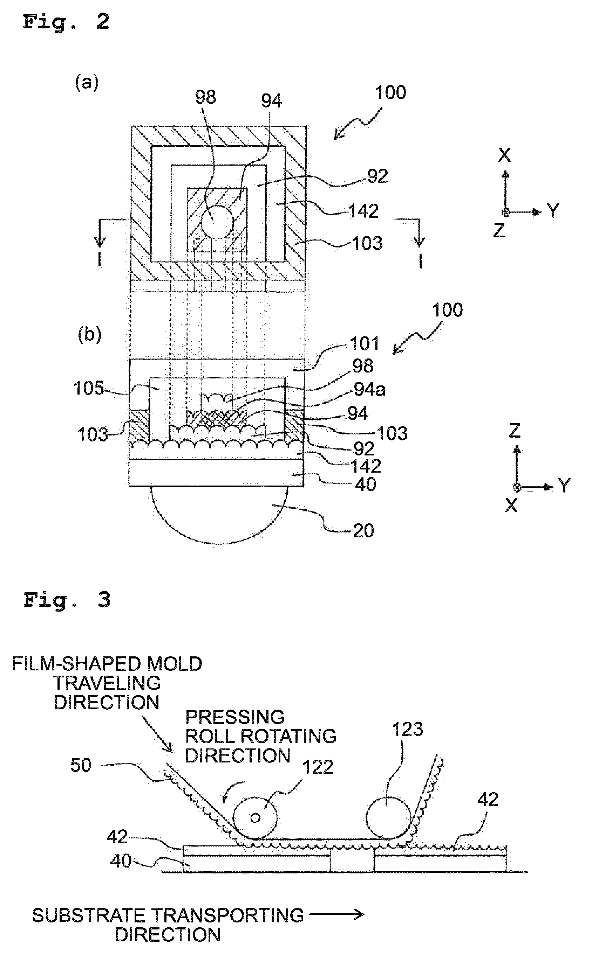

The optical element 100 may include a sealing member 101, as depicted in Figs. 2(a) and 2(b). The sealing member 101 is disposed to face the base member 40 so as to define a space (sealed space) 105 intervening therebetween. The first electrode 92, the organic layer 94 and the second electrode 98 are positioned inside the sealed space 105. The sealing member 101 can be fixed to the base member 40 with an adhesive layer 103. The adhesive layer 103 maybe located such that the adhesive layer 103 is arranged between the base member 40 and the sealing member 101 in the Z direction, and that the adhesive layer 103 surrounds the organic layer 94 in in the XY in-plane direction. Owing to the presence of the sealing member 101 and the adhesive layer 103, it is possible to prevent moisture and/or gas such as oxygen from entering into the inside of the sealed space 105. With this, any degradation of the organic layer 94, etc., is suppressed, which in turn improves the service life of the light emitting element 100. Further, in order to effectively extract the light emitted from the light emitting portion 94a, it is preferable that the adhesive layer 103 does not contact the light emitting portion 94a and that the adhesive layer 103 is formed to be apart from the light emitting portion 94a with a predetermined spacing distance (clearance). The predetermined spacing distance is preferably, for example, not less than 1 $\mu$m.

The sealing member 101 may be any member provided that it is made of a material having a high gas barrier property. Examples of the sealing member 101 include any publicly known gas barrier films used for packaging materials and the like, such as a plastic film in which silicon oxide or aluminum oxide is deposited; a laminate (stacked object) formed of a ceramic layer and an impact-attenuating polymer layer; metal foil laminated with a polymer film; a sealing can made of glass; a sealing can made of metal; and an engraved glass.

As the material of the adhesive layer 103, it is allowable to use, without any restriction, any adhesive which is generally used for glass or plastic substrate, etc., and which is exemplified for example by polyvinyl acetate-based adhesive; photo-curable and thermo-curable acrylic-based adhesives having a reactive vinyl group such as acrylic acid-based oligomer, methacrylic acid-based oligomer, etc.; epoxy resin adhesive; moisture-curable adhesive such as 2-cyanoacrylic acid ester; ethylene copolymer-based adhesive; polyester-based adhesive; polyimide-based adhesive, amino resin-based adhesive composed of urea resin, melamine resin or the like; phenolic resin-based adhesive; polyurethane-based adhesive; reactive (meth)acrylic-based adhesive; rubber-based adhesive; etc. Among these adhesives, particularly preferred adhesives include the acrylic-based adhesive, the epoxy-based adhesive, etc. among which the epoxy-based adhesive of which contraction (shrinkage) during the curing is small is preferred.

The epoxy-based adhesives include, for example, an epoxy resin composition made of an epoxy resin and a curing agent. The adhesive force of the epoxy resin composition is generated by its curing reaction which is brought about by mixing a compound containing an epoxy group with the curing agent containing amines and acid anhydride.

The epoxy-based adhesives usable in the present embodiment are exemplified, for example, by Cemedine EP-001 produced by CEMEDINE CO., LTD.; 3950, 3951 and 3952 of 3950 series, 2083, 2086 and 2087 of 2080 series, and 2230 and 2230B of 2230 series, and 3124C produced by THREEBOND HOLDINGS CO., LTD.; MOS07 and MOS10 of Bond MOS series produced by KONISHI CO., LTD.; ULTIGHT 1540 and the like of ULTIGHT 1500 series produced by TOHO KASEI CO., LTD.; and XNR5576/5576LV, XNR5516/5516HV/5516Z, XNR5570, T470/UR7116, T470/UR7134, T470/UR7132, T470/UR7124E-LV, and the like produced by NAGASE CHEMTEX CORPORATION.

The acrylic-based adhesives include, for example, an adhesive containing an acrylic-based pressure-sensitive adhesive component, an energy-ray curable component and a thermo-curable adhesive component. The acrylic-based adhesives usable in the present embodiment are exemplified, for example, by 3003, 3027B, 3033B, 3042B, and the like produced by THREEBOND HOLDINGS CO., LTD.; and Cemedine Y600, Cemedine Y600H, and the like produced by CEMEDINE CO., LTD.

Other than the those listed above, the rubber-based adhesives include, for example, one obtained in such a manner that adhesive elastomer, an adhesion-imparting agent, a softening agent, and the like are mixed with one another. The adhesive elastomer is at least one kind of adhesive elastomer selected, for example, from natural rubber composed mainly of cis-1,4-polyisoprene; synthetic rubber composed mainly of styrene-butadiene rubber (SBR), polyisobutylene, butyl rubber, and the like; and block rubber composed mainly of styrene-butadiene-styrene copolymer rubber (SBS), styrene-isoprene-styrene copolymer rubber (SIS), and the like. The adhesion-imparting agent is a thermoplastic resin containing an amorphous oligomer (middle-molecular weight polymer of a dimer or more), the amorphous oligomer being a liquid or solid at normal temperature and having a molecular weight in a range of hundreds to about ten thousand, such as a rosin-based resin, a terpene-based resin, a petroleum resin, and a chroman-indene resin. The softening agent is exemplified, for example, by mineral oil, liquid polybutene, liquid polyisobutylene, and liquid polyacrylic ester.

Examples of vinyl ether-based adhesives include an adhesive composed of a homopolymer such as vinyl methyl ether, vinyl ethyl ether or vinyl isobutyl ether, an adhesive composed of a copolymer of acrylate and vinyl ether such as vinyl methyl ether, vinyl ethyl ether or vinyl isobutyl ether (adhesive elastomer), and the like. Each of the above-described vinyl ether-based adhesives may be mixed with the above-described adhesion-imparting agent, softening agent, or the like.

Examples of silicone-based adhesives include one obtained in such a manner that a polymer (or adhesive elastomer) containing a residual silanol group (SiOH) at an end of a polymer chain is mixed with the above-described adhesion-imparting agent, softening agent, or the like. The polymer containing a residual silanol group is represented by polydimethylsiloxane or polydimethyldiphenylsiloxane having high molecular weight.

The sealed space 105 may be filled with an inactive or inert gas or the like. $N_2$ can be used as the inactive gas, and instead of $N_2$, a noble gas such as He or Ar is preferably used. Further, a noble gas obtained by mixing He with Ar is also preferable. The ratio of the inactive gas in gases is preferably in a range of 90% by volume to 100% by volume. Alternatively, the sealed space 105 may be filled with infilling such as a solid or liquid resin, glass, an inactive oil such as a fluorine-based inactive oil, or a gel material. It is preferred that the infilling be transparent or cloudy. Further, a water-absorbing substance may be disposed in the sealed space 105. The water-absorbing substance is exemplified, for example, by barium oxide. Specifically, for example, high-purity barium oxide powder produced by SIGMA-ALDRICH CO., LLC. can be disposed in the sealed space 105 by being put or stuck on the sealing member 101 by using a fluororesin-based semi-transparent film with adhesive (MICROTEX S-NTF8031Q produced by NITTO DENKO CORPORATION) or the like. Alternatively, any commercially available water-absorbing substances produced, for example, by W.L. GORE & ASSOCIATES and FUTABA CORPORATION are preferably used.

Next, an explanation will be given about a method for manufacturing the light emitting element 100 of the embodiment, with reference to Figs. 1(a) and 1(b) and Figs. 2(a) and 2(b). The manufacturing method mainly includes a step for manufacturing (forming) a stacked body including the concave-convex structure layer 142, the first electrode, the organic layer and the second electrode on the base member 40, and step of attaching the lens member 20 to the base member 40. The method may further include a step of sealing the stacked body. The respective steps are sequentially explained as follows. Note that in the following, a case wherein the concave-convex structure layer is formed by using the sol-gel material will be explained as an example.

<Step of Forming Stacked Body>

At first, the concave-convex structure layer 142 is formed on the base member 40. The concave-convex structure layer 142 can be formed, for example, by a method explained below.

In order to form the concave-convex structure layer 142 by the sol-gel method, a solution of a sol-gel material is firstly prepared. The concave-convex structure layer is preferably formed of an inorganic material since the inorganic material has an excellent heat resistance. As the material for forming the concave-convex structure layer, it is possible to use, in particular, silica, a Ti-based material ($TiO_2$, etc.), a material based on ITO (indium tin oxide), or a sol-gel material such as ZnO, $ZrO_2$, $Al_2O_3$, $TiO_2$, ZnS, ZrO, $BaTiO_3$ or $SrTiO_2$, etc. For example, in a case that a concave-convex structure layer formed of silica is formed on the base member by the sol-gel method, a sol-gel material of metal alkoxide (silica precursor) is prepared as the material for forming the concave-convex structure layer. Examples of the silica precursor include tetraalkoxide monomers represented by tetraalkoxysilane such as tetramethoxysilane (TMOS), tetraethoxysilane (TEOS), tetra-i-propoxysilane, tetra-n-propoxysilane, tetra-i-butoxysilane, tetra-n-butoxysilane, tetra-sec-butoxysilane, and tetra-t-butoxysilane; trialkoxide monomers represented by trialkoxysilane such as methyltrimethoxysilane, ethyltrimethoxysilane, propyltrimethoxysilane, isopropyltrimethoxysilane, phenyltrimethoxysilane, methyltriethoxysilane (MTES), ethyltriethoxysilane, propyltriethoxysilane, isopropyltriethoxysilane, phenyltriethoxysilane, methyltripropoxysilane, ethyltripropoxysilane, propyltripropoxysilane, isopropyltripropoxysilane, phenyltripropoxysilane, methyltriisopropoxysilane, ethyltriisopropoxysilane, propyltriisopropoxysilane, isopropyltriisopropoxysilane, phenyltriisopropoxysilane, and tolyltriethoxysilane; dialkoxide monomers represented by dialkoxysilane such as dimethyldimethoxysilane, dimethyldiethoxysilane, dimethyldipropoxysilane, dimethyldiisopropoxysilane, dimethyldi-n-butoxysilane, dimethyldi-i-butoxysilane, dimethyldi-sec-butoxysilane, dimethyldi-t-butoxysilane, diethyldimethoxysilane, diethyldiethoxysilane, diethyldipropoxysilane, diethyldiisopropoxysilane, diethyldi-n-butoxysilane, diethyldi-i-butoxysilane, diethyldi-sec-butoxysilane, diethyldi-t-butoxysilane, dipropyldimethoxysilane, dipropyldiethoxysilane, dipropyldipropoxysilane, dipropyldiisopropoxysilane, dipropyldi-n-butoxysilane, dipropyldi-i-butoxysilane, dipropyldi-sec-butoxysilane, dipropyldi-t-butoxysilane, diisopropyldimethoxysilane, diisopropyldiethoxysilane, diisopropyldipropoxysilane, diisopropyldiisopropoxysilane, diisopropyldi-n-butoxysilane, diisopropyldi-i-butoxysilane, diisopropyldi-sec-butoxysilane, diisopropyldi-t-butoxysilane, diphenyldimethoxysilane, diphenyldiethoxysilane, diphenyldipropoxysilane, diphenyldiisopropoxysilane, diphenyldi-n-butoxysilane, diphenyldi-i-butoxysilane, diphenyldi-sec-butoxysilane, and diphenyldi-t-butoxysilane. Further, it is possible to use alkyltrialkoxysilane or dialkyldialkoxysilane which has alkyl group having C4 to C18 carbon atoms. It is also possible to use metal alkoxides including, for example, monomers having vinyl group such as vinyltrimethoxysilane and vinyltriethoxysilane; monomers having epoxy group such as 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, and 3-glycidoxypropyltriethoxysilane; monomers having styryl group such as p-styryltrimethoxysilane; monomers having methacrylic group such as 3-methacryloxypropylmethyldimethoxysilane, 3-methacryloxypropyltrimethoxysilane, 3-methacryloxypropylmethyldiethoxysilane, and 3-methacryloxypropyltriethoxysilane; monomers having acrylic group such as 3-acryloxypropyltrimethoxysilane; monomers having amino group such as N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethyl-butylidene)propylamine, and N-phenyl-3-aminopropyltrimethoxysilane; monomer having ureide group such as 3-ureidepropyltriethoxysilane; monomers having mercapto group such as 3-mercaptopropylmethyldimethoxysilane and 3-mercaptopropyltrimethoxysilane; monomers having sulfide group such as bis(triethoxysilylpropyl) tetrasulfide; monomers having isocyanate group such as 3-isocyanatopropyltriethoxysilane; polymers obtained by polymerizing the foregoing monomers in small amounts; and composite materials characterized in that functional group and/or polymer is/are introduced into a part of the material as described above. Further, a part of or all of the alkyl group and the phenyl group of these compounds may be substituted with fluorine. Further, examples of the silica precursor include metal acetylacetonate, metal carboxylate, oxychloride, chloride, and mixtures thereof. The silica precursor, however, is not limited to the above examples. In addition to Si, examples of the metal species include Ti, Sn, Al, Zn, Zr, In, and mixtures thereof, but are not limited to these. It is also possible to use any appropriate mixture of precursors of the oxides of the above metals. Further, it is possible to use, as the silica precursor, a silane coupling agent having, in its molecule, a hydrolysis group having the affinity and the reactivity with silica and an organic functional group having the water-repellence. For example, the silane coupling agent is exemplified by silane monomer such as n-octyltriethoxysilane, methyltriethoxysilane, and methyltrimethoxysilane; vinylsilane such as vinyltriethoxysilane, vinyltrimethoxysilane, vinyltris(2-methoxyethoxy)silane, and vinylmethyldimethoxysilane; methacrylsilane such as 3-methacryloxypropyltriethoxysilane and 3-methacryloxypropyltrimethoxysilane; epoxysilane such as 2-(3,4-epoxycyclohexyl)ethyltrimethoxysilane, 3-glycidoxypropyltrimethoxysilane, and 3-glycidoxypropyltriethoxysilane; mercaptosilane such as 3-mercaptopropyltrimethoxysilane and 3-mercaptopropyltriethoxysilane; sulfursilane such as 3-octanoylthio-1-propyltriethoxysilane; aminosilane such as 3-aminopropyltriethoxysilane, 3-aminopropyltrimethoxysilane, N-(2-aminoethyl)-3-aminopropyltrimethoxysilane, N-(2-aminoethyl)-3-aminopropylmethyldimethoxysilane, and 3-(N-phenyl)-aminopropyltrimethoxysilane; and polymers obtained by polymerizing the monomers as described above. Further, it is also allowable to add a surfactant to these materials so as to form a mesoporous concave-convex structure layer.

In a case that a mixture of TEOS and MTES is used as the sol-gel material solution, the mixture ratio thereof can be, for example, 1:1 in a molar ratio. The sol-gel material produces amorphous silica by being subjected to hydrolysis and polycondensation reaction. An acid such as hydrochloric acid or an alkali such as ammonia is added in order to adjust the pH of the solution as a synthesis condition. The pH is preferably not more than 4 or not less than 10. Water may be added to perform the hydrolysis. The amount of water to be added can be not less than 1.5 times, with respect to the amount of metal alkoxide species, in the molar ratio.

The solvent of the sol-gel material solution is exemplified, for example, by alcohols such as methanol, ethanol, isopropyl alcohol (IPA), and butanol; aliphatic hydrocarbons such as hexane, heptane, octane, decane, and cyclohexane; aromatic hydrocarbons such as benzene, toluene, xylene, and mesitylene; ethers such as diethyl ether, tetrahydrofuran, and dioxane; ketones such as acetone, methyl ethyl ketone, isophorone, and cyclohexanone; ether alcohols such as butoxyethyl ether, hexyloxyethyl alcohol, methoxy-2-propanol, and benzyloxyethanol; glycols such as ethylene glycol and propylene glycol; glycol ethers such as ethylene glycol dimethyl ether, diethylene glycol dimethyl ether, and propylene glycol monomethyl ether acetate; esters such as ethyl acetate, ethyl lactate, and $\gamma$-butyrolactone; phenols such as phenol and chlorophenol; amides such as N,N-dimethylformamide, N,N-dimethylacetamide, and N-methylpyrrolidone; halogen-containing solvents such as chloroform, methylene chloride, tetrachloroethane, monochlorobenzene, and dichlorobenzene; hetero-element containing compounds such as carbon disulfide; water; and mixture solvents thereof. Especially, ethanol and isopropyl alcohol are preferable. Further, a mixture of water and ethanol and a mixture of water and isopropyl alcohol are also preferable.

As an additive of the sol-gel material solution, it is possible to use polyethylene glycol, polyethylene oxide, hydroxypropylcellulose, and polyvinyl alcohol for viscosity adjustment; alkanolamine such as triethanolamine, $\beta$-diketone such as acetylacetone, $\beta$-ketoester, formamid, dimetylformamide, dioxane, and the like, as a solution stabilizer. Further, as an additive of the sol-gel material solution, it is possible to use a material generating an acid or alkali by being irradiated with a light such as an energy ray represented by ultraviolet ray including an excimer UV light. By adding such a material, it is possible to cure the sol-gel material solution by irradiating a light to the sol-gel material solution.

The base member is coated with the sol-gel material solution prepared as described above. It is allowable to perform a surface treatment for or provide an easy-adhesion layer on the base member in order to improve the adhesion property, and to provide a gas barrier layer in order to keep out moisture and/or gas such as oxygen. As the coating method for coating the base member with the sol-gel material, it is possible to use any coating method including, for example, a bar coating method, a spin coating method, a spray coating method, a dip coating method, a die coating method, and an ink-jet method. The bar coating method, the die coating method, and the spin coating method are preferable, because the base member having a relatively large area can be coated uniformly with the sol-gel material and the coating can be quickly completed prior to curing (gelation) of the sol-gel material.

After the coating of the base member with the sol-gel material, the base member may be kept (held) in the atmospheric air or under reduced pressure in order to evaporate the solvent contained in the coating film. In a case that the holding time of the base member is short, the viscosity of the coating film is too low to transfer the concave-convex pattern to the coating film. On the other hand, in a case that the holding time of the base member is too long, the polymerization reaction of the precursor proceeds and the viscosity of the coating film increases too much, which in turn makes it impossible to transfer the concave-convex pattern to the coating film. Further, after the coating of the base member with the sol-gel material, the polymerization reaction of the precursor proceeds as the evaporation of the solvent proceeds, and the physical property such as the viscosity of sol-gel material also changes in a short time. From the viewpoint of the stability of concave-convex pattern formation, it is preferred that drying time which enables a good pattern transfer have a sufficiently wide range. The range of the drying time which enables a good pattern transfer can be adjusted by the drying temperature (holding temperature), the drying pressure, the kind of sol-gel material, the ratio of mixed sol-gel materials, the solvent amount used at the time of preparation of the sol-gel material (concentration of sol-gel material), etc.

Next, a mold for concave-convex pattern transfer is used to transfer the concave-convex pattern of the mold to the coating film made of the sol-gel material, thereby forming the concave-convex structure layer 142. A film-shaped mold or metal mold can be used as the mold, and it is preferred that a flexible film-shaped mold be used as the mold. In this situation, a pressing roll may be used to press the mold against the coating film formed of the sol-gel material. The roll process using the pressing roll has the following advantages over the pressing system. For example, the period of time during which the mold and the coating film are brought in contact with each other is short, and hence it is possible to prevent any deformation or collapse of pattern which would be otherwise caused by the difference in thermal expansion coefficient among the mold, the base member, and a stage on which the base member is placed, etc.; it is possible to prevent the generation of bubbles of gas in the pattern due to the bumping of the solvent in the sol-gel material solution or to prevent any trace or mark of gas from remaining; it is possible to reduce the transfer pressure and the releasing force (peeling force) owing to the line contact with the base member (coating film), thereby making it possible to easily handle a base member with larger area; and no bubble is included during the pressing. Further, the base member may be heated while the mold is being pressed thereto. Fig. 3 depicts an example in which the mold is pressed against the coating film of the sol-gel material by using the pressing roll. As depicted in Fig. 3, the concave-convex pattern of a film-shaped mold 50 can be transferred to a coating film 42 on the base member 40 by sending the film-shaped mold 50 between a pressing roll 122 and the base member 40 being transported immediately below the pressing roll 122. Namely, when the film-shaped mold 50 is pressed against the coating film 42 with the pressing roll 122, the surface of the coating film 42 on the base member 40 is coated (covered) with the film-shaped mold 50 while the film-shaped mold 50 and the base member 40 are synchronously transported. In this situation, by rotating the pressing roll 122 while pressing the pressing roll 122 against the back surface (surface on the side opposite to the surface in which the concave-convex pattern is formed) of the film-shaped mold 50, the film-shaped mold 50 moves with the base member 40 while being brought into tight contact with the base member 40. In order to send the long film-shaped mold 50 to the pressing roll 122, such a configuration is conveniently used wherein the film-shaped mold 50 is fed directly from a film roll around which the long film-shaped mold 50 is wound.

The film-shaped mold used in this embodiment may be a film-shaped or sheet-shaped mold having a concave-convex transfer pattern on a surface thereof. The mold is made, for example, of organic materials such as silicone resin, polyethylene terephthalate (PET), polyethylene naphthalate (PEN), polycarbonate (PC), cycloolefin polymer (COP), polymethyl methacrylate (PMMA), polystyrene (PS), polyimide (PI), and polyarylate. The concave-convex pattern may be formed directly in (on) each of the materials, or may be formed in (on) a concave-convex forming material with which a base member (substrate sheet) formed of the above-mentioned materials is coated. It is possible to use a photo-curable resin, a thermo-curable resin, and a thermoplastic resin as the concave-convex forming material.

The size of the film-shape mold, in particular, the length thereof can be set appropriately based on the size of the optical substrate to be mass-produced and/or the number of optical substrates (the number of lots) continuously produced in a single manufacturing process. For example, the film-shaped mold may be a long mold having a length of not less than 10 meters, and the pattern transfer may be performed continuously on a plurality of base members while the film-shaped mold wound around a roll is continuously fed from the roll. The film-shaped mold may have a width in a range of 50 mm to 3000 mm, and a thickness in a range of 1 $\mu$m to 500 $\mu$m. A surface treatment or an easy-adhesion treatment may be performed to improve the adhesion property between the base member (substrate sheet) and the concave-convex forming material. Further, a mold-release treatment may be performed on each surface of the concave-convex pattern of the film shaped mold as needed. The concave-convex pattern may be formed to have any profile or shape by any method. The concave-convex pattern of the film-shaped mold may be any pattern such as a lens structure or a structure having the light diffusion function, light diffraction function, etc.; a dot structure; a stripe structure formed of lines and spaces; a pillar structure formed of cylindrical shaped structures, conical shaped structures, truncated cone shaped structures, triangle pole shaped structures, triangular pyramid shaped structures, truncated triangular pyramid shaped structures, square pole shaped structures, quadrangular pyramid shaped structures, truncated quadrangular pyramid shaped structures, polygonal column shaped structures, polygonal pyramid shaped structures, or truncated polygonal pyramid shaped structures; or a hole structure. Among the above-described structures, an irregular concave-convex structure in which the pitches of concavities and convexities are non-uniform and the orientations of concavities and convexities have no directionality. The average pitch of concavities and convexities can be, for example, in a range of 100 nm to 1500 nm, more preferably in a range of 200 nm to 1200 nm. The average value of the depth distribution of concavities and convexities is preferably in a range of 20 nm to 200 nm, more preferably in a range of 30 nm to 150 nm. The standard deviation of the depth of convexities and concavities is preferably in a range of 10 nm to 100 nm, more preferably in a range of 15 nm to 75 nm. The light(s) scattered and/or diffracted by such a concave-convex pattern is/are a light having a wavelength in a relatively broad band, rather than a light having a single wavelength or a light having a wavelength in a narrow band, and the scattered and/or diffracted light(s) have no directivity, and travel(s) in various directions.

After the mold is pressed against the coating film of the sol-gel material, the coating film may be subjected to pre-baking. The pre-baking promotes gelation of the coating film to solidify the pattern, which in turn allows the pattern to be less likely to be collapsed during releasing or peeling. In a case that the pre-baking is performed, heating is preferably performed at temperatures of 40°C to 150°C in the atmosphere. It is not necessarily required to perform the pre-baking. On the other hand, in a case that the material generating an acid or alkali by being irradiated with a light such as ultraviolet ray is added to the sol-gel material solution, it is allowable for example to irradiate the energy ray represented by ultraviolet ray including the excimer UV light onto the coating film, rather than performing the pre-baking for the coating film.

After the pressing with the mold or the pre-baking for the coating film of the sol-gel material, the mold is released or peeled off from the coating film of the sol-gel material. As the method for releasing the mold, any publicly known releasing method can be adopted. The mold may be released while being heated. In this case, gas generated from the coating film is allowed to escape, thereby preventing any generation of bubbles in the coating film. In a case that the roll process is used, the releasing force (peeling force) may be smaller than that in the pressing system using a plate-shaped mold, and it is possible to easily release the mold from the coating film without allowing the coating film to remain on the mold. In particular, since the pressing is performed while the coating film is being heated, the reaction progresses more easily, which in turn facilitates the releasing of the mold from the coating film immediately after the pressing. In order to improve the releasing property (peeling property) of the mold, it is possible to use a peeling roll (releasing roll). As depicted in Fig. 3, a peeling roll (releasing roll) 123 is disposed on the downstream side of the pressing roll 122, and the peeling roll 123 rotates and supports the film-shaped mold 50 while urging the film-shaped mold 50 toward the coating film 42. With this configuration, it is possible to maintain a state that the film-shaped mold 50 is attached to the coating film 42 as long as a distance between the pressing roll 122 and the peeling roll 123 (for a certain period of time). Then, a path of the film-shaped mold 50 is changed so that the film-shaped mold 50 is pulled up above the peeling roll 123 on the downstream side of the peeling roll 123, thereby peeling off (releasing) the film-shaped mold 50 from the coating film 42 in which concavities and convexities are formed. The pre-baking or the heating for the coating film 42 may be performed during a period in which the film-shaped mold 50 is attached to the coating film 42. Note that in a case of using the peeling roll 123, the releasing of the mold 50 becomes easier by releasing the mold 50 from the coating film 42 while heating the coating film 42, for example, at temperatures of 40°C to 150°C.

After the mold is released from the coating film 42, the coating film 42 may be cured. Accordingly, the concave-convex structure layer 142 as depicted in Figs. 1(a) and 1(b) and Figs. 2(a) and 2(b) is formed. In this embodiment, the concave-convex structure layer made of the sol-gel material can be cured by main baking. The hydroxyl group or the like contained in silica (amorphous silica) constructing the coating film is desorbed or eliminated (subjected to the leaving) by the main baking, and the coating film is further hardened or solidified. The main baking is preferably performed at a temperature in a range of 200°C to 1200°C for a duration of time in a range of about 5 minutes to about 6 hours. In such a manner, the coating film is cured, and the concave-convex structure layer 142 having a concave-convex pattern which corresponds to the concave-convex pattern of the mold is formed. In this situation, in a case that the concave-convex structure layer 142 is made of silica, silica is amorphous, crystalline, or in a mixture state of the amorphous and the crystalline, depending on the baking temperature and the baking time. On the other hand, in a case that a material, which generates an acid or alkali by being irradiated with a light such as ultraviolet ray, is added to the sol-gel material solution, the coating film 42 can be cured by irradiation with an energy ray represented by ultraviolet ray including the excimer UV light, rather than baking the coating film 42.

A covering layer (coating layer) may be formed on the surface of the concave-convex structure layer 142. It is preferred that the thickness of the covering layer be in a range of 25% to 150% of the standard deviation of depth of concavities and convexities of the concave-convex structure layer 142. Such a covering layer can cover any foreign matter and defect which might be present on the surface of the concave-convex structure layer. Thus, it is possible to effectively prevent any leak current in the light emitting element 100 which is to be manufactured. The light emitting element 100, in which the covering layer having a thickness within the above range has been formed on the concave-convex structure layer, has good light extraction efficiency.

As the material of the covering layer (covering material (coating material)), it is possible to use materials similar to the sol-gel material usable as the material for the concave-convex structure layer. It is preferable, however, to use a material identical to the material used for forming the concave-convex structure layer. In a case that the covering material is identical to the material of the concave-convex structure layer, the reflection of light at an interface between the covering layer and the concave-convex structure layer can be suppressed. As a solvent for the sol-gel material solution which is to be used for forming the covering layer, it is possible to use a solvent similar to that usable for the concave-convex structure layer. As an additive for the sol-gel material solution for forming the covering layer, it is possible to use an additive similar to the additive usable for the material for the concave-convex structure layer. As the sol-gel material solution for the covering layer, it is preferred to use a diluted solution obtained by further diluting, with a solvent, the sol-gel material solution used for forming the concave-convex structure layer so that the diluted solution is weaker than the sol-gel material solution forming the concave-convex structure layer. With this, the covering layer can be easily formed to have a predetermined film thickness (thickness) which is thinner than the concave-convex structure layer.

The covering material may be formed of an inorganic material such as $TiO_2$, $ZnO$, $ZnS$, $ZrO$, $BaTiO_3$, $SrTiO_2$. etc. Among the above materials, $TiO_2$ is preferred in view of the film formation performance (coating property) and the refractive index.

It is allowable to form the covering layer by using a curable resin material as the covering material. Similarly regarding the concave-convex structure layer, the curable resin can be exemplified by resins such as photo-curable resins, thermo-curable resins, moisture curing type resins, chemical curing type resins (two-liquid mixing type resins), etc. Specifically, the curable resin can be exemplified by various resins including, for example, monomers, oligomers, and polymers of those based on epoxy, acrylic, methacrylic, vinyl ether, oxetane, urethane, melamine, urea, polyester, polyolefin, phenol, cross-linking type liquid crystal, fluorine, silicone, polyamide, etc.

A silane coupling agent may be used as the covering material to form the covering layer. With the use of the silane coupling agent, it is possible to improve the adhesion property between the covering layer and a layer, such as an electrode, to be formed on the covering layer, which in turn develops the resistance in a cleaning step and a high temperature treatment step included in the production process of the light emitting element. The type of the silane coupling agent used for the covering layer is not especially limited. As the silane coupling agent, it is possible to use, for example, an organic compound represented by $RSiX_3$ (R is an organic functional group containing at least one selected from a vinyl group, a glycidoxy group, an acrylic group, a methacryl group, an amino group, and a mercapto group, and X is a halogen element or an alkoxyl group).

The covering material may be that obtained by mixing an inorganic material or a curable resin material with an ultraviolet absorbent material. The ultraviolet absorbent material has the function or effect to prevent deterioration of the film by absorbing ultraviolet rays and converting the light energy into something harmless such as heat. Any publicly known agent may be used as the ultraviolet absorbent material. Those usable as the ultraviolet absorbent material include, for example, benzotriazole-based absorbents, triazine-based absorbents, salicylic acid derivative-based absorbents, benzophenone-based absorbents, etc.

It is also allowable to use a polysilazane solution to be applied as the covering material on the concave-convex structure layer, and a coating film thus formed may be formed into ceramic (subjected to the silica reforming or modification) to thereby form a covering layer composed of silica. Further, it is also allowable to use the polysilazane solution as the concave-convex structure layer material to thereby form the concave-convex structure layer 142. Note that the term "polysilazane" means a polymer having a silicon-nitrogen bond, is an inorganic polymer comprising Si-N, Si-H, N-H, or the like, and is a precursor of a ceramics such as $SiO_2$, $Si_3N_4$, or $SiO_xN_y$ which is an intermediate solid solution of $SiO_2$ and $Si_3N_4$. A compound, which is ceramized at relatively low temperature and is modified into silica, as represented by the following formula (1) described in Japanese Patent Application Laid-open No. H8-112879, is more preferable.

Formula (1): -Si (R1) (R2)-N (R3)-

In the formula (1), R1, R2, and R3 each represent a hydrogen atom, an alkyl group, an alkenyl group, a cycloalkyl group, an aryl group, an alkylsilyl group, an alkylamino group, or an alkoxy group.

Among the compounds represented by the formula (1), perhydropolysilazane (referred to also as PHPS) in which all of R1, R2, and R3 are hydrogen atoms and organopolysilazane in which a part of the hydrogen bonded to Si thereof is substituted by, for example, an alkyl group are particularly preferred.

As other examples of the polysilazane ceramized at low temperature, it is also possible to use: silicon alkoxide-added polysilazane obtained by reacting polysilazane with silicon alkoxide (for example, see Japanese Patent Laid-Open No. 5-238827); glycidol-added polysilazane obtained by reaction with glycidol (for example, see Japanese Patent Laid-open No. 6-122852); alcohol-added polysilazane obtained by reaction with alcohol (for example, see Japanese Patent Laid-open No. 6-240208); metal carboxylate-added polysilazane obtained by reaction with metal carboxylate (for example, see Japanese Patent Laid-Open No. 6-299118); acetylacetonato complex-added polysilazane obtained by reaction with an acetylacetonato complex containing a metal (for example, see Japanese Patent Laid-Open No. 6-306329); metallic fine particles-added polysilazane obtained by addition of metallic fine particles (for example, see Japanese Patent Laid-Open No. 7-196986), and the like.

As the solvent of the polysilazane solution, it is possible to use hydrocarbon solvents such as aliphatic hydrocarbons, alicyclic hydrocarbons, and aromatic hydrocarbons; halogenated hydrocarbon solvents; and ethers such as aliphatic ethers and alicyclic ethers. Amine or a metal catalyst may be added in order to promote the modification into a silicon oxide compound.

Further, a hydrophobization treatment may be performed on the surface of the concave-convex structure layer (the surface of the covering layer in a case that the covering layer is formed). Any known method for the hydrophobization treatment may be used. For example, regarding the surface of silica, the hydrophobization treatment can be performed with dimethyl dichlorosilane, trimethyl alkoxysilan, etc., or with a silicone oil and a trimethylsilylating agent such as hexamethyl-disilazane. Alternatively, it is also allowable to employ a surface treatment method for a surface of metal oxide powder with supercritical carbon dioxide. By allowing the surface of the concave-convex structure layer to have the hydrophobicity, it is possible to easily remove moisture from the substrate during a manufacturing process of the optical element, thereby making it possible to prevent, in the optical element, any generation of defect, such as dark spots, and any deterioration of the device.

Further, it is also allowable to provide a gas barrier layer on the surface of the concave-convex structure layer or on the surface of the covering layer, in order to keep out moisture and/or gas such as oxygen.

An explanation will be given about an exemplary method for producing the film-shaped mold for the concave-convex pattern transfer which is suitably used for the formation of the concave-convex structure layer. A master block pattern for forming the concave-convex pattern of the mold is manufactured first. It is preferred that the concave-convex pattern of the master block be formed by a method of utilizing the self-organization or self-assembly (micro phase separation) of a block copolymer by heating, as described in International Publication No. WO2012/096368 of the applicants of the present invention (hereinafter referred to as "BCP (Block Copolymer) thermal annealing method" as appropriate), or a method of utilizing the self-organization or self-assembly of a block copolymer under a solvent atmosphere, as described in International Publication No. WO2013/161454 of the applicants of the present invention (hereinafter referred to as "BCP solvent annealing method" as appropriate), or a method of heating and cooling a vapor deposited film on a polymer film to form concavities and convexities of wrinkles on a surface of polymer, as disclosed in International Publication No. WO2011/007878 A1 of the applicants of the present invention (hereinafter referred to as "BKL (Buckling) method" as appropriate). The photolithography method may be utilized instead of the BCP thermal annealing method, BKL method, and BCP solvent annealing method. In addition to the above methods, the concave-convex pattern of the master block can be manufactured by, for example, microfabrication or fine-processing methods including a cutting (cutting and processing) or machining method, an electron-beam direct imaging method, a particle beam processing method, a scanning probe processing method and the like; and a fine-processing method using the self-organization or self-assembly of fine particles; or a sandblasting method. In a case that the pattern is formed by the BCP thermal annealing method or the BCP solvent annealing method, although any material can be used as the material for forming the pattern, the material is preferably a block copolymer composed of a combination of two selected from the group consisting of a styrene-based polymer such as polystyren; polyalkyl methacrylate such as polymethyl methacrylate; polyethylene oxide; polybutadiene; polyisoprene; polyvinylpyridine; and polylactic acid. Further, the concave-convex pattern obtained by the solvent annealing process may be subjected to etching by irradiation with energy rays represented by ultraviolet rays such as excimer UV light, or etching by a dry etching method such as reactive ion etching (RIE). The concave-convex pattern which has been subjected to such an etching may be subjected to the heating process.

After forming the master block with the pattern by means of the BCP thermal annealing method, BKL method, or BCP solvent annealing method, further, a mold to which the pattern is transferred can be formed by an electroforming method or the like, as follows. At first, a seed layer functioning as an electroconductive layer for an electroforming process can be formed on the master block, which has the pattern to be transferred, by means of non-electrolytic plating, sputtering, vapor deposition, or the like. The thickness of the seed layer is preferably not less than 10 nm to uniformize a current density during the subsequent electroforming process, and thereby to uniformize the thickness of a metal layer which is to be accumulated by the subsequent electroforming process. As the material of the seed layer, it is possible to use, for example, nickel, copper, gold, silver, platinum, titanium, cobalt, tin, zinc, chrome, gold-cobalt alloy, gold-nickel alloy, boron-nickel alloy, solder, copper-nickel-chromium alloy, tin-nickel alloy, nickel-palladium alloy, nickel-cobalt-phosphorus alloy, or alloy thereof. Subsequently, a metal layer is accumulated on the seed layer by the electroforming (electroplating). The entire thickness of the metal layer including the thickness of the seed layer can be, for example, in a range of 10 $\mu$m to 3000 $\mu$m. As the material of the metal layer accumulated by the electroforming, it is possible to use any of metal species as described above which can be used as the seed layer. In view of the easiness of the subsequent processes for forming the mold such as pressing to the resin layer, releasing, and cleaning, the formed metal layer desirably has appropriate hardness and thickness.

The metal layer including the seed layer obtained as described above is released (peeled off) from the master block having the concave-convex structure to obtain a metal substrate. As the releasing method, the metal layer may be peeled off physically, or the materials composing the pattern of the master block may be dissolved to be removed by using an organic solvent dissolving them, such as toluene, tetrahydrofuran (THF), and chloroform. When the metal substrate is peeled off from the master block, a remaining material component on the metal substrate can be removed by cleaning. As the cleaning method, it is possible to use wet cleaning using a surfactant etc., or dry cleaning using ultraviolet rays and/or plasma. Alternatively, for example, the remaining material component may be allowed to be attached to or adhere to an adhesive agent or a bonding agent then be removed. Accordingly, the metal substrate to which the pattern has been transferred from the master block can be obtained.

The concave-convex structure layer 142 can be formed by using the obtained metal substrate as the mold for concave-convex pattern transfer and by transferring the concave-convex pattern of the mold to the coating film of the sol-gel material. Further, with the obtained metal substrate, a flexible mold such as the film-shaped mold can be manufactured by transferring the concave-convex structure (pattern) of the obtained metal substrate to a film-shaped supporting substrate. For example, after the supporting substrate is coated with a curable resin, the resin layer is cured while the concave-convex structure of the metal substrate is being pressed against the resin layer. The supporting substrate is exemplified, for example, by base members made of inorganic materials such as glass, quarts, silicon, etc.; base members made of organic materials such as silicone resin, polyethylene terephthalate (PET), polyethylene naphthalate (PEN), polycarbonate (PC), cycloolefin polymer (COP), polymethyl methacrylate (PMMA), polystyrene (PS), polyimide (PI), polyarylate, etc.; and metallic materials such as nickel, copper, aluminium, etc. The thickness of the supporting substrate may be in a range of 1 $\mu$m to 500 $\mu$m.

As the curable resin, it is possible to use resins such as photo-curable resins, thermo-curable resins, moisture curing type resins, chemical curing type resins (two-liquid mixing type resins), etc. Specifically, the curable resin can be exemplified by various resins such as monomers, oligomers, polymers, etc., of resins based on epoxy, acrylic, methacrylic, vinyl ether, oxetane, urethane, melamine, urea, polyester, polyolefin, phenol, cross-linking type liquid crystal, fluorine, silicone, polyamide, etc. The thickness of the curable resin is preferably in a range of 0.5 $\mu$m to 500 $\mu$m. In a case that the thickness is less than the lower limit, heights of concavities and convexities formed on the surface of the cured resin layer are likely to be insufficient; on the other hand, in a case that the thickness exceeds the upper limit, the influence of volume change of the resin upon curing is likely to be so large that there is such a fear that the shapes of concavities and convexities might not be formed satisfactorily.

As a method for coating the supporting substrate with the curable resin, it is possible for example to adopt various coating methods such as the spin coating method, spray coating method, dip coating method, dropping method, gravure printing method, screen printing method, relief printing method, die coating method, curtain coating method, ink-jet method, sputtering method, etc. Further, the condition for curing the curable resin depends on the kind of the resin to be used. For example, the curing temperature is preferably in a range of room temperature to 250°C, and the curing time is preferably in a range of 0.5 minute to 3 hours. Alternatively, a method may be employed in which the curable resin is cured by being irradiated with energy rays such as ultraviolet light or electron beams. In such a case, the amount of the irradiation is preferably in a range of 20 mJ/cm$^2$ to 5 J/cm$^2$.

Subsequently, the metal substrate is detached from the curable resin layer after the curing. The method for detaching the metal substrate is not limited to a mechanical releasing (exfoliating or peeling off) method, and any publicly known method can be adopted. Accordingly, it is possible to obtain a mold having the cured resin layer, in which concavities and convexities are formed, on the supporting substrate.

After the concave-convex structure layer 142 is formed on the base member 40 in the manner as described above, the base member 40 and the concave-convex structure layer 142 are cleaned with a brush in order to remove foreign matters and the like adhered to the base member 40 and the concave-convex structure layer 142, and then an organic matter and the like is removed with an organic solvent and an alkaline cleaning agent using an aqueous solvent. Next, as depicted in Fig. 1(b) and Fig. 2(b), the first electrode 92 is stacked on the concave-convex structure layer 142 such that the concave-convex structure formed in the surface of the concave-convex structure layer 142 is maintained on the first electrode 92 as well. Accordingly, the first electrode 92 having the concave-convex pattern is formed. As a method for stacking the first electrode 92, it is possible to appropriately use any publicly known method including, for example, the evaporation method, the sputtering method, and the spin coating method. Among these methods, the sputtering method is preferably employed from the viewpoint of improving the adhesion property. Note that during the sputtering, the base member may be exposed to a high temperature of about 300°C. The first electrode 92 as a formed film is coated with photoresist, and then the photoresist is exposed with a mask pattern for the first electrode, and developed by a developer. After that, the first electrode is etched with an etching solution, thereby obtaining the patterned first electrode 92 having a predetermined pattern. It is preferred to clean the obtained first electrode 92 with a brush and to remove any organic matter and the like with an organic solvent and an alkaline cleaning agent using an aqueous solvent, followed by performing a UV ozone treatment.

Next, the organic layer 94 is stacked on the first electrode 92. As a method for stacking the organic layer 94, it is possible to appropriately use any publicly known method including, for example, the evaporation method, the sputtering method, the spin coating method, and the die coating method. The patterning of the organic layer 94 can be performed by any publicly known patterning method including arranging a mask having a predetermined shape on the base member, and performing film formation therefor, etc.

Subsequently, the second electrode (metal electrode) 98 is stacked on the organic layer 94. The metal electrode 98 can be stacked by any publicly known method such as the evaporation method and the sputtering method. The patterning of the metal electrode 98 can be performed by any publicly known patterning method including arranging a mask having a predetermined shape on the base member, and performing film formation therefor, etc.

<Lens Member Arranging Step>

The lens member 20 is arranged on the surface (the surface serving as a light-extracting surface after the formation of the optical element), of the base member 40, on the side opposite to the surface in which the concave-convex structure layer 142 is formed. The lens member 20 can be attached on the baes member 40 via a pressure-sensitive adhesive layer and/or an adhesive layer. In such a case that the lens member 20 is attached to the base member 40 via the pressure-sensitive adhesive layer and/or the adhesive layer, for example, the adhesive or pressure-sensitive adhesive is applied to the surface of the base member 40 opposite to the surface having the concave-convex structure layer 142 arranged thereon, and the lens member 20 is arranged on the applied adhesive or the applied pressure-sensitive adhesive, etc., thereby making it possible to arrange the lens member 20 on the base member 40.

As the material(s) for the pressure-sensitive adhesive layer and/or for the adhesive layer, it is possible to appropriately use any publicly known material by which the lens member 20 can be adhered on the base member 40. Such material(s) include, for example, acrylic-based pressure-sensitive adhesive; ethylene-vinyl acetate copolymer; natural rubber-based pressure-sensitive adhesive; synthetic rubber-based pressure-sensitive adhesive such as polyisobutylene, butyl rubber, styrene-butylene-styrene copolymer, and styrene-isoprene-styrene block copolymer; polyurethane-based pressure-sensitive adhesive; and polyester-based pressure-sensitive adhesive; alternatively, it is allowable to use a commercially available product (for example, photo-curable adhesives of UV-curing type NOA60, NOA61, NOA71, NOA72, NOA81 produced by NORLAND INC.; UV-3400 produced by TOAGOSEI CO., LTD.). Among the above-described pressure-sensitive adhesives and adhesives, it is preferable to use a pressure-sensitive adhesive and/or an adhesive having the refractive index similar to that of the base member 40, from the viewpoint that the pressure-sensitive adhesive layer and/or the adhesive layer do not (does not) affect the optical path of the light exiting from the base member 40. The method of applying such a pressure-sensitive adhesive and/or adhesive is not particularly limited, and any publicly known method can be adopted as appropriate. Note that the pressure-sensitive adhesive and/or the adhesive may be applied to either one of the base member 40 and the lens member 20. Further, note that such a step of arranging the lens member may be executed before forming the concave-convex structure layer 142, after forming the concave-convex structure layer 142, or after performing a sealing step (to be described later on); the order for executing these steps is not particularly limited. With the method as described above, an optical element 100 provided with the lens member 20 as depicted in Figs. 1(a) and 1(b) is formed.

<Sealing step>

Further, it is allowable to seal the stacked body, formed in the above-described step for forming the stacked body, by attaching a sealing member 101, as depicted in Figs. 2(a) and 2(b). In order to obtain such a sealing structure, at first, an adhesive layer 103 is formed on the surface, of the base member 40, having the concave-convex structure layer 142 arranged thereon, such that the adhesive layer 103 surrounds the organic layer 94. The adhesive layer 103 can be formed at a desired position by applying an adhesive by using a scannable dispenser and/or a movable stage, etc. Further, the adhesive layer 103 having a desired line width can be formed by controlling the scanning velocity of the dispenser and the discharge amount of the adhesive from the dispenser. Next, the sealing member 101 is disposed above the concave-convex structure layer 142, the first electrode 92, the organic layer 94, and the metal electrode 98 to face the base member 40 and then the sealing member 101 is adhered (connected) to the base member 40 via the adhesive layer 103, thereby sealing the space 105 between the base member 40 and the sealing member 101. In a case that the adhesive layer 103 is formed of a material which is curable by being irradiated with an energy ray, then the adhesive layer 103 is cured by being irradiated with the energy ray after the sealing. For example, in a case that the adhesive layer 103 is made of the photo-curable adhesive, the adhesive layer 103 can be cured by being irradiated with a light in a range from the ultraviolet region to the visible region which is obtained by a high-pressure mercury vapor lamp or a halogen lamp and which is radiated from the side of the sealing member or the side of the base member. On the other hand, in a case that the adhesive layer 103 is made of the thermo-curable adhesive, the adhesive layer 103 is cured by being heated, for example, at a temperature in a range of 50°C to 150°C. Accordingly, the base member 40 and the sealing member 101 are formed integrally, to thereby allow the organic layer 94 to be arranged inside the sealed space 105.

After the formation of the organic layer 94, it is preferred that the organic layer 94 be sealed, for example, in a nitrogen atmosphere (for example, by using a glove box wherein the inside thereof is replaced with high-purity nitrogen gas of not less than five-nines (99.999%) purity) without any contact with atmospheric air. In the above-described sealing step, the sealing member 101 is arranged after the adhesive layer 103 is formed on the base member 40. The adhesive layer 103, however, may be formed as follows. Namely, the sealing member 101 is arranged to face the base member 40 with a space intervening therebetween, and then an adhesive is injected into the space to form the adhesive layer 103. By the manufacturing method as described above, the optical member 100 provided with the sealing member 101 as depicted in Figs. 2(a) and 2(b) is manufactured.

Note that while the concave-convex structure layer 142 is formed by using the sol-gel material in the embodiment described above, the curable resin material may be used, other than the above-described inorganic material. As the curable resin, it is possible to use, for example, photo-curable resins, thermo-curable resins, moisture curing type resins, chemical curing type resins (two-liquid mixing type resins), etc. Specifically, the curable resin is exemplified by various resins including, for example, monomers, oligomers, and polymers of those based on epoxy, acrylic, methacrylic, vinyl ether, oxetane, urethane, melamine, urea, polyester, polyolefin, phenol, cross-linking type liquid crystal, fluorine, silicone, polyamide, etc. Further, it is allowable to provide a gas barrier layer on the surface of the concave-convex structure layer 142 in order to keep out moisture and/or gas such as oxygen.

In a case of forming the concave-convex structure layer 142 by using the curable resin, the concave-convex pattern of the mold can be transferred to the curable resin layer after the base member has been coated with the curable resin, by for example the following manner. Namely, the base member is coated with the curable resin, and then the coating film (curable resin layer) is cured while the mold having a fine concave-convex pattern is being pressed against the curable resin layer. The curable resin may be applied after being diluted with an organic solvent. As the organic solvent used in this case, an organic solvent, which can dissolve the resin to be cured, can be selected and used. For example, it is possible to select the organic solvent from among publicly known organic solvents including, for example, alcohol-based solvents such as methanol, ethanol, and isopropyl alcohol (IPA); and ketone-based solvents such as acetone, methyl ethyl ketone, and methyl isobutyl ketone (MIBK). As the method for applying the curable resin, for example, it is possible to adopt various coating methods such as the spin coating method, spray coating method, dip coating method, dropping method, gravure printing method, screen printing method, relief printing method, die coating method, curtain coating method, ink-jet method, sputtering method, etc. As the mold having the fine concave-convex pattern, it is possible to use a desired mold such as the film-shaped mold, metal mold, etc. Further, the condition for curing the curable resin depends on the kind of the resin to be used. For example, the curing temperature is preferably in a range of room temperature to 250°C, and the curing time is preferably in a range of 0.5 minute to 3 hours. Alternatively, a method may be employed in which the curable resin is cured by being irradiated with an energy ray such as ultraviolet light or electron beam. In such a case, the amount of the irradiation is preferably in a range of 20 mJ/cm$^2$ to 5 J/cm$^2$.

The material for the concave-convex structure layer may be a material obtained by mixing an inorganic material or a curable resin material with an ultraviolet absorbent material. The ultraviolet absorbent material has the function or effect to prevent the deterioration of the film by absorbing ultraviolet rays and converting light energy into something harmless such as heat. Any publicly known ultraviolet absorbing material may be used as an ultraviolet absorbent agent.

Those usable as the ultraviolet absorbent material include, for example, benzotriazole-based absorbents, triazine-based absorbents, salicylic acid derivative-based absorbents, benzophenone-based absorbents, etc.

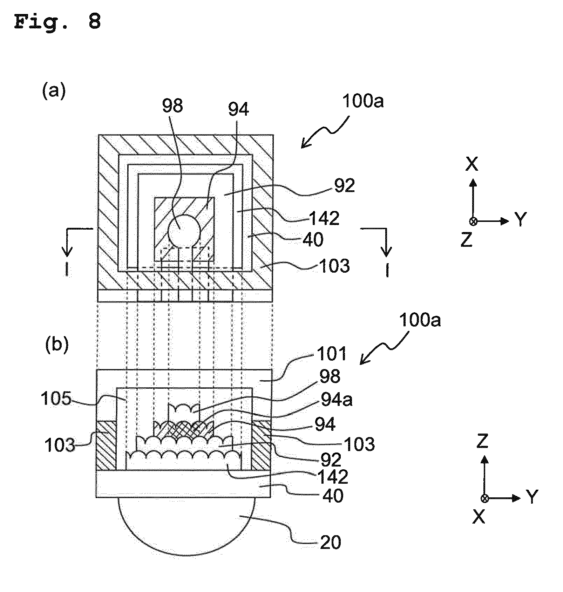

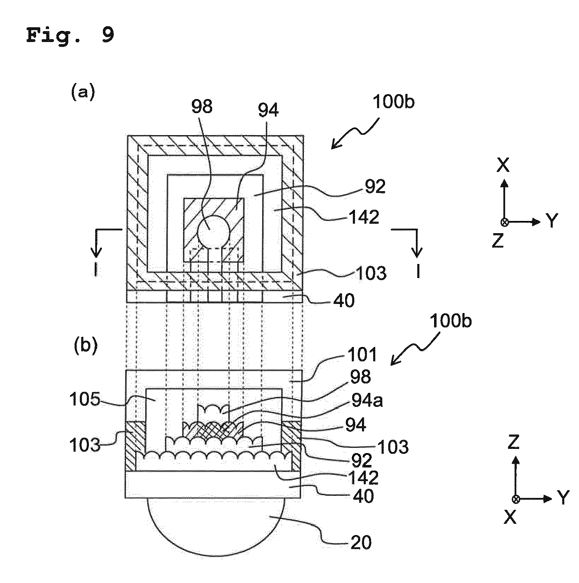

Further, in the embodiment as depicted in Figs. 2(a) and 2(b), the adhesive layer 103 adheres the sealing member 101 to the base member 40 via the concave-convex structure layer 142. It is allowable, however, that the adhesive layer 103 is formed directly on the base member 40, as depicted in Figs. 8(a) and 8(b). By providing such an arrangement, the concave-convex structure layer 142 can be arranged inside the sealed space 105. In such an arrangement, it is possible to prevent the light emitting element from being degraded due to any moisture and/or oxygen which would otherwise enter into the sealed space 105 via a portion of the concave-convex structure layer 142 exposed to the outside of the sealed space 105. Furthermore, it is allowable to provide such an arrangement wherein the adhesive layer 103 makes contact with both of the concave-convex structure layer 142 and the base member 40, as depicted in Figs. 9(a) and 9(b). In this configuration, the concave-convex structure layer 142 is arranged such that the concave-convex structure layer 142 is not exposed to the outside of the adhesive layer 103 and the sealed space 105. In such an arrangement, it is possible to prevent the light emitting element from being degraded due to any moisture and/or oxygen which would otherwise enter into the sealed space 105 via a portion of the concave-convex structure layer 142 exposed to the outside of the adhesive layer 103 and the sealed space 105, and to obtain such an effect of improving the adhesive force of the adhesive layer 103 owing to the surface area effect and/or the catching effect of the concave-convex structure layer 142.

EXAMPLES

In the following description, the optical element according to the present invention will be specifically explained with examples and comparative examples. The present invention, however, is not limited to these examples and comparative examples. At first, light emitting elements (organic EL elements) were produced respectively in Example 1 and Comparative Examples 1 to 3 as follows, and the chromaticity angle dependency (the change in color due to the field angle) was evaluated for each of the light emitting elements.

[Example 1]

<Manufacture of film mold>

At first, a film mold having a concave-convex surface was manufactured by the BCP solvent annealing method in order to manufacture a diffraction grating substrate. There was prepared a block copolymer produced by POLYMER SOURCE INC., and made of polystyrene (hereinafter referred to as "PS" in an abbreviated manner as appropriate) and polymethyl methacrylate (hereinafter referred to as "PMMA" in an abbreviated manner as appropriate) as described below.

Mn of PS segment = 680,000
Mn of PMMA segment = 580,000
Mn of block copolymer = 1,260,000
Volume ratio between PS segment and PMMA segment (PS:PMMA) = 57:43
Molecular weight distribution (Mw/Mn) = 1.28
Tg of PS segment = 107°C
Tg of PMMA segment = 134°C

The volume ratio between the PS segment and the PMMA segment (the PS segment: the PMMA segment) in the block copolymer was calculated on the assumption that the density of polystyrene was 1.05 g/cm$^3$ and the density of polymethyl methacrylate was 1.19 g/cm$^3$. The number average molecular weights (Mn) and the weight average molecular weights (Mw) of polymer segments or polymers were measured by using a gel permeation chromatography (Model No.: "GPC-8020" manufactured by TOSOH CORPORATION, in which TSK-GEL SuperH1000, SuperH2000, SuperH3000, and SuperH4000 were connected in series). The glass transition temperatures (Tg) of the polymer segments were measured by using a differential scanning calorimeter (manufactured by PERKIN-ELMER, INC. under the product name of "DSC7"), while the temperature was raised at a rate of temperature rise of 20°C/min over a temperature range of 0°C to 200°C. The solubility parameters of polystyrene and polymethyl methacrylate were 9.0 and 9.3 respectively (see "Kagaku Binran Ouyou Hen" (Handbook of Chemistry, Applied Chemistry), Revised 2nd edition).

Toluene was added to 230 mg of the block copolymer and 57.5 mg of Polyethylene Glycol 2050 (average Mn = 2050) manufactured by SIGMA-ALDRICH CO. LLC. as polyethylene oxide so that the total amount thereof was 15 g, followed by dissolving the mixture. Accordingly, a solution of the block copolymer was prepared.

The solution of the block copolymer was filtered through a membrane filter having a pore diameter of 0.5 μm to obtain a block copolymer solution. A glass substrate was coated with a mixed solution containing 1 g of KBM-5103 manufactured by SHIN-ETSU SILICONE (SHIN-ETSU CHEMICAL, CO., LTD.), 1 g of ion-exchanged water, 0.1 ml of acetic acid, and 19 g of isopropyl alcohol, by means of the spin coating (which was performed for 10 seconds with rotation speed of 500 rpm, and then performed continuously for 45 seconds with rotation speed of 800 rpm). The glass substrate was treated for 15 minutes at 130°C, and thus a silane coupling treated glass was obtained. The silane coupling treated glass as the base member was coated with the obtained block copolymer solution by means of the spin coating to provide a thickness in a range of 140 nm to 160 nm. The spin coating was performed for 10 seconds at a rotation speed of 200 rpm and then was performed for 30 seconds at a rotation speed of 300 rpm.

Then, the base member on which the thin film was formed was subjected to a solvent annealing process by being stationarily placed in a desiccator filled with chloroform vapor in advance at room temperature for 24 hours. Inside the desiccator (volume: 5 L), a screw-type container charged with 100 g of chloroform was placed, and the atmosphere inside the desiccator was filled with chloroform at the saturated vapor pressure. Concavities and convexities were observed on the surface of the thin film after the solvent annealing process, and it was found that the block copolymer forming the thin film underwent the micro phase separation. The cross section of the thin film was observed by using a transmission electron microscope (TEM) (H-7100FA manufactured by HITACHI, LTD.). As a result, the circular cross section of the PS portion was aligned in two tiers (stages or rows) in a direction perpendicular to the surface of the substrate (height direction) while the circular cross sections of the PS portion were separated from each other in a direction parallel to the surface of the substrate. When considering together with an analysis image obtained by using an atomic force microscope, it was revealed that the PS portion was subjected to the phase separation to form a horizontal cylinder structure from the PMMA portion. A state was given, in which the PS portion existing as the core (island) was surrounded by the PMMA portion (sea).

About 20 nm of a thin nickel layer was formed as a current seed layer by performing the sputtering on the surface of the thin film processed to have the wave-like shape by means of the solvent annealing process as described above. Subsequently, the base member equipped with the thin film was immersed in a nickel sulfamate bath and subjected to an electroforming process (maximum current density: 0.05 A/cm$^2$) at a temperature of 50°C so as to precipitate nickel until the thickness became 250 $\mu$m. The base member equipped with the thin film was mechanically peeled off or released from the nickel electroforming body obtained as described above. Subsequently, the nickel electroforming body was immersed in a tetrahydrofuran solvent for 2 hours, and then the nickel electroforming body was coated with an acrylic-based UV curable resin, followed by being cured and peeled off. This process was repeated three times, and thus polymer component(s) adhered to a part of the surface of the electroforming body was (were) removed. After that, the nickel electroforming body was immersed in Chemisol 2303 manufactured by THE JAPAN CEE-BEE CHEMICAL CO., LTD., and was cleaned or washed while being stirred or agitated for 2 hours at 50°C. Thereafter, the UV ozone treatment was applied to the nickel electroforming body for 10 minutes.

Subsequently, the nickel electroforming body was immersed in HD-2101TH manufactured by DAIKIN CHEMICALS SALES, CO., LTD. for about 1 minute and was dried, and then stationarily placed overnight. The next day, the nickel electroforming body was immersed in HDTH manufactured by DAIKIN CHEMICALS SALES, CO., LTD. and was subjected to an ultrasonic cleaning (washing) process for about 1 minute. In such a manner, a nickel mold for which a mold-release treatment had been performed was obtained.

Subsequently, a PET substrate (COSMOSHINE A-4100 manufactured by TOYOBO CO., LTD.) was coated with a fluorine-based UV curable resin. The fluorine-based UV curable resin was cured by irradiation with ultraviolet light at 600 mJ/cm$^2$ while the nickel mold was pressed thereagainst. After curing of the resin, the nickel mold was exfoliated or peeled off from the cured resin. Accordingly, the film mold, which was composed of the PET substrate with the resin film to which the surface profile (surface shape) of the nickel mold was transferred, was obtained.

<Formation of concave-convex structure layer>

0.75 mol of tetraethoxysilane (TEOS) and 0.25 mol of dimethyldiethoxysilane (DMDES) were added dropwise to a mixture solution of 22 mol of ethanol, 5 mol of water, 0.004 mol of concentrated hydrochloric acid and 4 mol of acetylacetone, and further added with a surfactant S-386 (manufactured by AGC SEIMI CHEMICAL CO., LTD.) as an additive at a concentration of 0.5 wt%, followed by being stirred or agitated for 2 hours at a temperature of 23 °C and a humidity of 45% to obtain a SiO$_2$ sol-gel material solution. The sol-gel material solution was applied onto an alkali-free glass substrate of which size was 100 mm x 100 mm x 0.7 mm (thickness) and of which and refractive index was 1.517 ($\lambda$ = 589 nm) (OA10GF produced by NIPPON ELECTRIC GLASS CO., LTD.) by means of the bar coating, thereby forming a coating film of the sol-gel material. Doctor Blade (manufactured by YOSHIMITSU SEIKI CO., LTD.) was used as a bar coater. The doctor blade was designed such that the thickness of the coating film was 5 $\mu$m. However, the doctor blade was adjusted such that the thickness of the coating film was 40 $\mu$m by sticking an imide tape having a thickness of 35 $\mu$m to the doctor blade. After the elapse of 60 seconds from the application of the sol-gel material solution (material of the concave-convex structure layer) onto the glass substrate, the film mold manufactured as described above was pressed against the coating film on the glass substrate by use of the pressing roll heated to 80 °C while the pressing roll was moved and rotated. After the completion of pressing against the coating film, the film mold was released from the coating film on the glass substrate and the coating film on the glass substrate was subjected to the main baking by being heated for 60 minutes in an oven of 300 °C. Accordingly, the concave-convex structure layer in which the concave-convex pattern of the film mold was transferred was formed on the glass substrate. Note that the pressing roll used was a roll which included a heater therein and had the outer circumference covered with heat-resistant silicon of a thickness of 4 mm, the roll having a roll diameter ($\varphi$) of 50 mm and a length of 350 mm in an axial direction of the shaft.

An analysis image of the shape of the concavities and convexities on the surface of the concave-convex pattern of the concave-convex structure layer was obtained by using an atomic force microscope (a scanning probe microscope equipped with an environment control unit "Nanonavi II Station/E-sweep" manufactured by HITACHI HIGH-TECH SCIENCE CORPORATION). Analysis conditions of the atomic force microscope were as follows.

Measurement mode: dynamic force mode
Cantilever: SI-DF40 (material: Si, lever width: 40 $\mu$m, diameter of tip of chip: 10 nm)
Measurement atmosphere: in air
Measurement temperature: 25 °C

<Average depth of concavities and convexities>

A concavity and convexity analysis image was obtained as described above by performing a measurement in a randomly selected measuring region of 10 $\mu$m square (length: 10 $\mu$m, width: 10 $\mu$m) at an arbitrary position in the concave-convex structure layer. Distances between randomly selected concave portions and convex portions in the depth direction were measured at not less than 100 points in the concavity and convexity analysis image, and the average of the distances was calculated as the average depth of the concavities and convexities. The average depth of the concave-convex pattern of the concave-convex structure layer obtained by the analysis image in this example was 70 nm.

<Fourier-transformed image of concavity and convexity analysis image>

A concavity and convexity analysis image was obtained as described above by performing a measurement in a randomly selected measuring region of 10 $\mu$m square (length: 10 $\mu$m, width: 10 $\mu$m) in the concave-convex structure layer. The obtained concavity and convexity analysis image was subjected to the flat processing including primary inclination correction, and then subjected to the two-dimensional fast Fourier transform processing. Thus, a Fourier-transformed image was obtained. It was confirmed that the Fourier-transformed image showed a circular pattern substantially centered at an origin at which an absolute value of wavenumber was 0 $\mu$m$^{-1}$, and that the circular pattern was present within a region where the absolute value of wavenumber was in a range of not more than 10 $\mu$m$^{-1}$.

The circular pattern of the Fourier-transformed image is a pattern observed due to gathering of bright spots in the Fourier-transformed image. The term "circular" herein means that the pattern of the gathering of the bright spots looks like a substantially circular shape, and is a concept further including a case where a part of the contour of the circular pattern looks like a convex shape or a concave shape. The pattern of the gathering of the bright spots may look like a substantially annular shape, and this case is expressed as the term "annular". It is noted that the term "annular" is a concept further including a case where a shape of an outer circle or inner circle of the ring looks like a substantially circular shape and a case where a part of the contour of the outer circle or the inner circle of the ring looks like a convex shape or a concave shape. Further, the phrase "the circular or annular pattern is present within a region where the absolute value of wavenumber is not more than 10 $\mu$m$^{-1}$ (more preferably in a range of 0.667 $\mu$m$^{-1}$ to 10 $\mu$m$^{-1}$, further preferably in a range of 0.833 $\mu$m$^{-1}$ to 5 $\mu$m$^{-1}$)" means that not less than 30% (more preferably not less than 50%, further more preferably not less than 80%, and particularly preferably not less than 90%) of bright spots forming the Fourier-transformed image are present within a region where the absolute value of wavenumber is not more than 10 $\mu$m$^{-1}$ (more preferably in a range of 0.667 $\mu$m$^{-1}$ to 10 $\mu$m$^{-1}$, and further preferably in a range of 0.833 $\mu$m$^{-1}$ to 5 $\mu$m$^{-1}$). Regarding the relationship between the pattern of the concave-convex structure and the Fourier-transformed image, the followings have been revealed. Namely, in a case that the concave-convex structure itself has neither the pitch distribution nor the directivity, the Fourier-transformed image appears to have a random pattern (no pattern). On the other hand, in a case that the concave-convex structure is entirely isotropic in an XY direction but has the pitch distribution, a circular or annular Fourier-transformed image appears. Further, in a case that the concave-convex structure has a single pitch, the annular shape appeared in the Fourier-transformed image tends to be sharp.

The two-dimensional fast Fourier transform processing on the concavity and convexity analysis image can be easily performed by electronic image processing by using a computer equipped with software for the two-dimensional fast Fourier transform processing.

<Average pitch of concavities and convexities>

A concavity and convexity analysis image was obtained as described above by performing a measurement in a randomly selected measuring region of 10 $\mu$m square (length: 10 $\mu$m, width: 10 $\mu$m) in the concave-convex structure layer. Distances between randomly selected adjacent convex portions or between randomly selected adjacent concave portions were measured at not less than 100 points in the concavity and convexity analysis image, and the average of the distances was calculated as the average pitch of the concavities and convexities. The average pitch of the concave-convex pattern of the concave-convex structure layer calculated using the analysis image obtained in this example was 900 nm.

<Average value of depth distribution of concavities and convexities>

A concavity and convexity analysis image was obtained by performing a measurement in a randomly selected measuring region of 10 $\mu$m square (length: 10 $\mu$m, width: 10 $\mu$m) in the concave-convex structure layer. While doing so, the data of the depth of concavities and convexities was determined at each of not less than 16,384 (vertical: 128 points x horizontal: 128 points) measuring points in the measuring region on the nanometer scale. By using E-sweep in this example, a measurement at 65,536 points (vertical: 256 points x horizontal: 256 points) (a measurement with a resolution of 256 pixels x 256 pixels) was conducted in a measuring region of 3 $\mu$m square. With respect to the depth of concavities and convexities (unit: nm) measured in such a manner, at first, a measurement point "P" was determined, among all the measurement points, which was the highest from the surface of the substrate. Then, a plane which included the measurement point P and which was parallel to the surface of the substrate was determined as a reference plane (horizontal plane), and a depth value from the reference plane (difference obtained by subtracting, from the value of height from the substrate at the measurement point P, the height from the substrate at each of the measurement points) was obtained as the data of depth of concavities and convexities. Note that such a depth data of the concavities and convexities was able to be obtained, for example, by performing automatic calculation with software in the E-sweep, and the value obtained by the automatic calculation in such a manner was able to be utilized as the data of depth of concavities and convexities. After obtaining the data of depth of concavity and convexity at each of the measurement points in this manner, the average value (m) of the depth distribution of the concavities and convexities was able to be determined by calculation according to the following formula (I):

[Formula I]

$$m = \frac{1}{N}\sum_{i=1}^{N} x_i \qquad (\mathrm{I})$$

The average value (m) of depth distribution of concavities and convexities of the concave-convex structure layer obtained in this example was 70 nm.

<Standard deviation of depth of concavities and convexities>

Similar to the method for measuring the average value (m) of the depth distribution, the data of depth of the concavities and convexities were obtained by performing a measurement at not less than 16,384 measuring points (vertical: 128 points x horizontal: 128 points) in a measuring region of 10 $\mu$m square of the concave-convex structure layer. In this example, a measurement was performed adopting 65,536 measuring points (vertical: 256 points x horizontal: 256 points). Thereafter, the average value (m) of the depth distribution of the concavities and convexities and the standard deviation ($\sigma$) of depth of the concavities and convexities were calculated based on the data of depth of concavities and convexities of the respective measuring points. Note that it was possible to determine the average value (m) by the calculation according to the formula (I) as described above. On the other hand, it was possible to determine the standard deviation ($\sigma$) of depth of the concavities and convexities by calculation according to the following formula (II):

[Formula II]

$$\sigma = \sqrt{\frac{1}{N}\sum_{i=1}^{N}(x_i - m)^2} \qquad (\mathrm{II})$$

In the formula (II), "N" represents the total number of measuring points (the number of all the pixels), "$x_i$" represents the data of depth of the concavities and convexities at the i-th measuring point, and "m" represents the average value of the depth distribution of the concavities and convexities. The standard deviation ($\sigma1$) of depth of concavities and convexities in the concave-convex structure layer was 48.1 nm.

<Formation of Light Emitting Portion>

Next, an ITO film having a thickness of 120 nm was formed on the concave-convex structure layer by the sputtering method. Then, photoresist was applied on the ITO film and exposure was performed with a mask pattern for a transparent electrode (first electrode), and then the resist was developed with a developer and ITO was etched with an etching solution. Accordingly, a transparent electrode having a pattern as depicted in the schematic top view of Fig. 1(a) was obtained. The obtained transparent electrode was cleaned with a brush, and organic matter and the like was removed by an alkaline cleaner and an organic solvent. Then, the transparent electrode was subjected to a UV-ozone process. On the transparent electrode processed as described above, a hole transporting layer (4,4',4" tris(9-carbazole)triphenylamine, thickness: 35 nm), a light emitting layer (tris(2-phenylpyridinato)iridium(III) complex-doped 4,4',4"tris(9-carbazole)triphenylamine, thickness: 15 nm; tris(2-phenylpyridinato)iridium(III) complex-doped 1,3,5-tris(N-phenylbenzimidazole-2-yl)benzene, thickness: 15 nm), and an electron transporting layer (1,3,5-tris(N-phenylbenzimidazole-2-yl)benzene, thickness: 65 nm) were each stacked, as the organic layer, by a vapor deposition method. Further, a lithium fluoride layer (thickness: 1.5 nm) and a metal electrode (aluminum, thickness: 50 nm) were deposited on the stacked body (organic layer). During the film formation of the organic layer and the metal electrode, a patterning mask was arranged on the base member, and the organic layer and the metal electrode each having a predetermined shape were formed. The light emitting portion of the light emitting element of the embodiment was circular-shape having a diameter D2 of 4.2 mm.

<Arrangement of Lens Member>

A refraction liquid (produced by SHIMAZU DEVICE CORPORATION) was used as an adhesive, and a semispherical lens (produced by EDMUND OPTICS INC.) having a diameter D1 of 10 mm and refractive index of 1.517 ($\lambda$ = 589 nm) was arranged on a surface, of the glass substrate, on the side opposite to the surface of the glass substrate having the concave-convex structure layer formed thereon, thereby adhering the semispherical lens on the glass substrate. Note that the semispherical lens was arranged on the glass substrate such that the center of the semispherical lens and the center of the light emitting portion were coincident to each other in a plane view.
In the light emitting element produced in the above-described procedure, the ratio r1 (=D1/D2) of the diameter D2 of the light emitting portion to the diameter D1 of the semispherical lens was 0.42. Further, the distance d in the Z direction between the surface of the substrate having the semispherical lens arranged thereon and the center of the light emitting portion was substantially same as the thickness of the substrate which was 0.7 mm. Thus, in the light emitting element of Example 1, the ratio r2 (=d/D1) of the distance d to the diameter D1 of the semispherical lens was 0.07. Note that the schematic presentation of the planar and cross-sectional structures of the light emitting element produced as describe above are those as depicted in Figs. 1(a) and 1(b).

[Comparative Example 1]

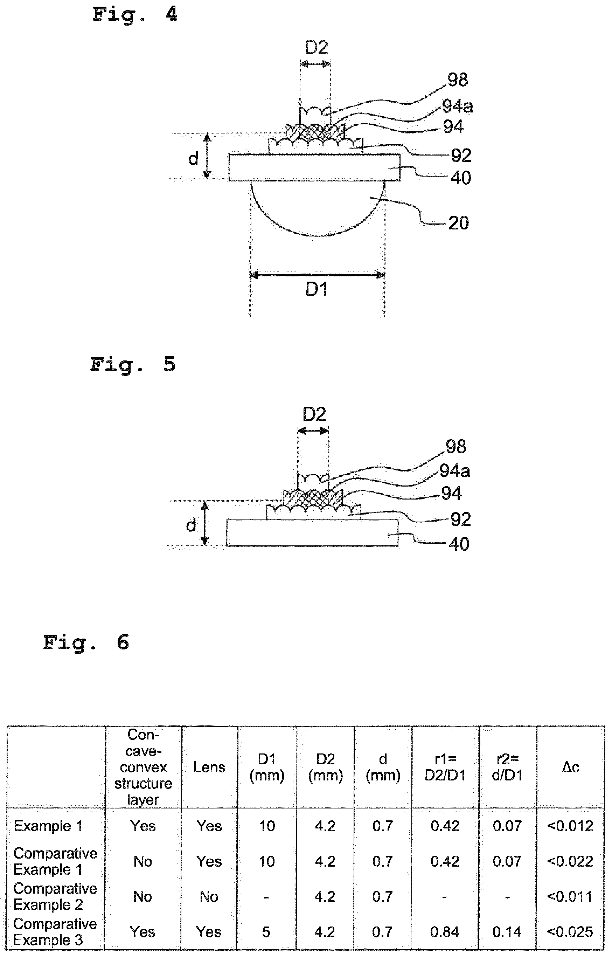

For the purpose of comparison with Example 1, a light emitting element of Comparative Example 1 was produced in a similar manner as in Example 1 except that the concave-convex structure layer was not formed and that the transparent electrode was directly formed on the base member. The schematic depiction of the cross-sectional structure of the produced light emitting element is as that depicted in Fig. 4.

[Comparative Example 2]

For the purpose of comparison with Example 1, a light emitting element of Comparative Example 2 was produced in a similar manner as in Example 1 except that the concave-convex structure layer was not formed, that the transparent electrode was directly formed on the base member, and further that the semispherical lens was not attached. The schematic depiction of the cross-sectional structure of the produced light emitting element is as that depicted in Fig. 5.

[Comparative Example 3]

A light emitting element of Comparative Example 3 was produced in a similar manner as in Example 1 except that a semispherical lens of which diameter was 5 mm was used, rather than using the semispherical lens of which diameter was 10 mm. In the light emitting element of Comparative Example 3, the ratio r1 (=D2/D1) was 0.84, and the ratio r2 (=d/D1) was 0.14.

<Evaluation of Chromaticity Angle Dependency>

Regarding the organic EL elements produced in Example 1 and Comparative Examples 1 to 3, a direction perpendicular to the glass substrate of the organic EL element (Z direction) was defined to have a measurement angle θ = 0°, and the emission spectral intensity in a wavelength range from 450 nm to 700 nm was measured at each of 33 measurement positions for which the measurements were made with the measurement angles θ ranging from -80° to 80° with an increment of 5°. The emission spectral intensity was measured by using a spectroradiometer produced by TOPCON TECHNOHOUSE CORPORATION under a product name of "SR-3A" as the measurement device, and by applying a voltage of about 4 V to the organic EL element to thereby measure the spectrum of a light emitted from an arbitrary point (measurement point) on the light emitting element. Further, in the measurement of the emission spectral intensity, the distance between a light receiving portion receiving the emission spectrum and a measurement point on the surface of the light emitting element was set to 100 cm.

For each of the measurement positions, the chromaticity coordinate in the u'v' chromaticity diagram (CIE 1976, USC (uniform-chromaticity-scale) chromaticity diagram) was obtained based on the data of the emission spectral intensity at each of the measurement positions, to thereby obtain a distance (Δc) between an address point in the u'v' chromaticity diagram at the measurement position of which measurement angle θ = 0° and an address point in the u'v' chromaticity diagram at each of the measurement positions for which the measurements were made with the measurement angles θ ranging from -80° to 80° with the increment of 5°. As the maximum value of the distance Δc was smaller, the chromaticity angle dependence of the light emitting element is meant to be smaller. The numerical value ranges of the obtained distances Δc are indicated in the table of Fig. 6.

While the light emitting element of Comparative Example 2 provided with none of the concave-convex structure layer and the semispherical lens had the distance Δc of less than 0.011, the light emitting element of Comparative Example 1 not provided with the concave-convex structure layer but provided only with the semispherical lens had the distance Δc of less than 0.022; from this, it was appreciated that the chromaticity angle dependency became great in a case that the semispherical lens was provided on the light emitting element. On the other hand, the light emitting element of Example 1 provided with both of the concave-convex structure layer and the semispherical lens had the distance Δc of less than 0.012; from this, it was appreciated that the chromaticity angle dependency caused by the semispherical lens could be suppressed in a case that the concave-convex structure layer was provided on the light emitting element. However, the light emitting element of Comparative Example 3, despite of being provided with both of the concave-convex structure layer and the semispherical lens, had the distance Δc of less than 0.025 that was a great value. From the fact that the light emitting element of Comparative Example 3 had the values of r1 and r2 that are different from those of the light emitting element of Example 1, it was appreciated that in order to produce a light emitting element in which the chromaticity angle dependency is small, namely a light emitting element having the distance Δc of a small value, it is necessary that the value of each of the ratios r1 and r2 of the light emitting element is set to be an appropriate value.

Next, light emitting elements were produced under various conditions in Examples 2 to 6 and Comparative Examples 4 to 22, and the current efficiency of each of the light emitting elements was evaluated.

[Example 2]

A light emitting element of Example 2 was produced in a similar manner as in Example 1 except that the masks for patterning of the transparent electrode and the metallic electrode were changed from those used in Example 1 to thereby change the diameter D2 of the light emitting portion to be 3.0 mm. In this light emitting element, the value of the ratio r1 was 0.30 and the value of the ratio r2 was 0.07.

[Comparative Example 4]

For the purpose of comparison with Example 2, a light emitting element of Comparative Example 4 was produced in a similar manner as in Example 2 except that the concave-convex structure layer was not formed and that the transparent electrode was directly formed on the base member. The cross-sectional structure of the produced light emitting element is schematically depicted in Fig. 4.

[Comparative Example 5]

For the purpose of comparison with Example 2, a light emitting element of Comparative Example 5 was produced in a similar manner as in Example 2 except that the concave-convex structure layer was not formed, that the transparent electrode was directly formed on the base member, and further that the semispherical lens was not attached. The cross-sectional structure of the produced light emitting element is schematically depicted in Fig. 5.

[Example 3]

A light emitting element of Example 3 was produced in a similar manner as in Example 2 except that the masks for patterning of the transparent electrode and the metallic electrode were changed from those used in Example 2 to thereby change the diameter D2 of the light emitting portion to be 5.2 mm. In this light emitting element, the value of the ratio r1 was 0.52 and the value of the ratio r2 was 0.07.

[Comparative Example 6]

For the purpose of comparison with Example 3, a light emitting element of Comparative Example 6 was produced in a similar manner as in Example 3 except that the concave-convex structure layer was not formed, and that the transparent electrode was directly formed on the base member.

[Comparative Example 7]

For the purpose of comparison with Example 3, a light emitting element of Comparative Example 7 was produced in a similar manner as in Example 3 except that the concave-convex structure layer was not formed, that the transparent electrode was directly formed on the base member, and further that the semispherical lens was not attached.

[Example 4]

A light emitting element of Example 4 was produced in a similar manner as in Example 2 except that the masks for patterning of the transparent electrode and the metallic electrode were changed from those used in Example 2 to thereby change the diameter D2 of the light emitting portion to be 6.7 mm. In this light emitting element, the value of the ratio r1 was 0.67 and the value of the ratio r2 was 0.07.

[Comparative Example 8]

For the purpose of comparison with Example 4, a light emitting element of Comparative Example 8 was produced in a similar manner as in Example 4 except that the concave-convex structure layer was not formed, and that the transparent electrode was directly formed on the base member.

[Comparative Example 9]

For the purpose of comparison with Example 4, a light emitting element of Comparative Example 9 was produced in a similar manner as in Example 4 except that the concave-convex structure layer was not formed, that the transparent electrode was directly formed on the base member, and further that the semispherical lens was not attached.

[Comparative Example 10]

A light emitting element of Comparative Example 10 was produced in a similar manner as in Example 2 except that the masks for patterning of the transparent electrode and the metallic electrode were changed from those used in Example 2 to thereby change the diameter D2 of the light emitting portion to be 7.9 mm. In this light emitting element, the value of the ratio r1 was 0.79 and the value of the ratio r2 was 0.07.

[Comparative Example 11]

For the purpose of comparison with Comparative Example 10, a light emitting element of Comparative Example 11 was produced in a similar manner as in Comparative Example 10 except that the concave-convex structure layer was not formed, and that the transparent electrode was directly formed on the base member.

[Comparative Example 12]

For the purpose of comparison with Comparative Example 10, a light emitting element of Comparative Example 12 was produced in a similar manner as in Comparative Example 10 except that the concave-convex structure layer was not formed, that the transparent electrode was directly formed on the base member, and further that the semispherical lens was not attached.

[Example 5]

A light emitting element of Example 5 was produced in a similar manner as in Example 2 except that, rather than using the alkali-free glass substrate having the thickness of 0.7 mm, two pieces of the alkali-free glass substrate overlapped and adhered to each other with a refraction liquid (produced by SHIMAZU DEVICE CORPORATION) as an adhesive were used as the base member. In Example 5, the thickness of the base member was 1.4 mm. In this light emitting element, the value of the ratio r1 was 0.30 and the value of the ratio r2 was 0.14.

[Comparative Example 13]

For the purpose of comparison with Example 5, a light emitting element of Comparative Example 13 was produced in a similar manner as in Example 5 except that the concave-convex structure layer was not formed, and that the transparent electrode was directly formed on the base member.

[Comparative Example 14]

For the purpose of comparison with Example 5, a light emitting element of Comparative Example 14 was produced in a similar manner as in Example 5 except that the concave-convex structure layer was not formed, that the transparent electrode was directly formed on the base member, and further that the semispherical lens was not attached.

[Example 6]

A light emitting element of Example 6 was produced in a similar manner as in Example 2 except that, rather than using the alkali-free glass substrate having the thickness of 0.7 mm, three pieces of the alkali-free glass substrate overlapped and adhered to one another with a refraction liquid (produced by SHIMAZU DEVICE CORPORATION) as an adhesive were used as the base member. In Example 6, the thickness of the base member was 2.1 mm. In this light emitting element, the value of the ratio r1 was 0.30 and the value of the ratio r2 was 0.21.

[Comparative Example 15]

For the purpose of comparison with Example 6, a light emitting element of Comparative Example 15 was produced in a similar manner as in Example 6 except that the concave-convex structure layer was not formed, and that the transparent electrode was directly formed on the base member.

[Comparative Example 16]

For the purpose of comparison with Example 6, a light emitting element of Comparative Example 16 was produced in a similar manner as in Example 6 except that the concave-convex structure layer was not formed, that the transparent electrode was directly formed on the base member, and further that the semispherical lens was not attached.

[Comparative Example 17]

A light emitting element of Comparative Example 17 was produced in a similar manner as in Example 2 except that, rather than using the alkali-free glass substrate having the thickness of 0.7 mm, four pieces of the alkali-free glass substrate overlapped and adhered to one another with a refraction liquid (produced by SHIMAZU DEVICE CORPORATION) as an adhesive were used as the base member. In Comparative Example 17, the thickness of the base member was 2.8 mm. In this light emitting element, the value of the ratio r1 was 0.30 and the value of the ratio r2 was 0.28.

[Comparative Example 18]

For the purpose of comparison with Comparative Example 17, a light emitting element of Comparative Example 18 was produced in a similar manner as in Comparative Example 17 except that the concave-convex structure layer was not formed, and that the transparent electrode was directly formed on the base member.

[Comparative Example 19]

For the purpose of comparison with Comparative Example 17, a light emitting element of Comparative Example 19 was produced in a similar manner as in Comparative Example 17 except that the concave-convex structure layer was not formed, that the transparent electrode was directly formed on the base member, and further that the semispherical lens was not attached.

[Comparative Example 20]

A light emitting element of Comparative Example 20 was produced in a similar manner as in Example 2 except that, rather than using the alkali-free glass substrate having the thickness of 0.7 mm, five pieces of the alkali-free glass substrate overlapped and adhered to one another with a refraction liquid (produced by SHIMAZU DEVICE CORPORATION) as an adhesive were used as the base member. In Comparative Example 20, the thickness of the base member was 3.5 mm. In this light emitting element, the value of the ratio r1 was 0.30 and the value of the ratio r2 was 0.35.

[Comparative Example 21]

For the purpose of comparison with Comparative Example 20, a light emitting element of Comparative Example 21 was produced in a similar manner as in Comparative Example 20 except that the concave-convex structure layer was not formed, and that the transparent electrode was directly formed on the base member.

[Comparative Example 22]

For the purpose of comparison with Comparative Example 20, a light emitting element of Comparative Example 22 was produced in a similar manner as in Comparative Example 20 except that the concave-convex structure layer was not formed, that the transparent electrode was directly formed on the base member, and further that the semispherical lens was not attached.

<Evaluation of Current Efficiency in Light Emitting Element>

Regarding each of the light emitting elements produced in Examples 2 to 6 and Comparative Examples 4 to 22, the current efficiency at luminance of 1000 cd/m$^2$ was obtained. Regarding the light emitting element produced in each of Example 2 and Comparative Example 4, the scale factor of the current efficiency thereof relative to the current efficiency of the light emitting element, produced in Comparative Example 5 and provided with none of the concave-convex structure layer and the lens member, was calculated. Similarly, regarding the light emitting element produced in each of Example 3 and Comparative Example 6, the scale factor of the current efficiency thereof relative to the current efficiency of the light emitting element produced in Comparative Example 7 was calculated; regarding the light emitting element produced in each of Example 4 and Comparative Example 8, the scale factor of the current efficiency thereof relative to the current efficiency of the light emitting element produced in Comparative Example 9 was calculated; regarding the light emitting element produced in each of Comparative Examples 10 and 11, the scale factor of the current efficiency thereof relative to the current efficiency of the light emitting element produced in Comparative Example 12 was calculated; regarding the light emitting element produced in each of Example 5 and Comparative Example 13, the scale factor of the current efficiency thereof relative to the current efficiency of the light emitting element produced in Comparative Example 14 was calculated; regarding the light emitting element produced in each of Example 6 and Comparative Example 5, the scale factor of the current efficiency thereof relative to the current efficiency of the light emitting element produced in Comparative Example 16 was calculated; regarding the light emitting element produced in each of Comparative Examples 17 and 18, the scale factor of the current efficiency thereof relative to the current efficiency of the light emitting element produced in Comparative Example 19 was calculated; and regarding the light emitting element produced in each of Comparative Examples 20 and 21, the scale factor of the current efficiency thereof relative to the current efficiency of the light emitting element produced in Comparative Example 22 was calculated. Note that the current efficiency was measured by the following method. Namely, voltage was applied to the organic EL element, and applied voltage V and electric current I flowing through the organic EL element were measured by a voltage monitor (model name: R6244 produced by ADC CORPORATION), and total luminous flux amount L was measured by a total luminous flux measuring device produced by SPECTRA CO-OP. The value of luminance (luminance value) L' was calculated from the thus obtained values of the applied voltage V, the electric current I and the total light flux amount L. Regarding the current efficiency, the following formula (F1) was used to calculate the current efficiency of the organic EL element:

$$\text{Current Efficiency} = (\text{L'}/\text{I}) \times \text{S} \text{ ...(F1)}$$

In the formula (F1), S represents a light emitting area of the element. Note that the value of the luminance L' was converted by the following formula (F2) while assuming that the light distribution characteristic of the organic EL element follows the Lambert law:

$$\text{L'} = \text{L}/\pi/\text{S} \text{ ...(F2)}$$

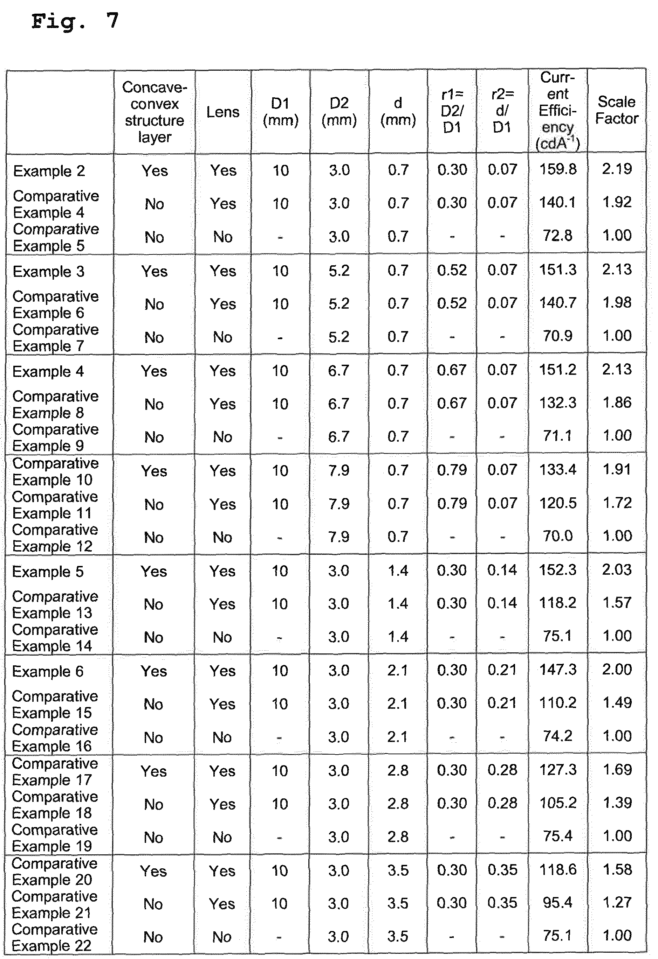

The results of calculation of the current efficiency are indicated in the table in Fig. 7. At first, the influence of the value of the ratio r1 on the current efficiency will be analyzed. In a case that the results of calculation of the scale factor of the current efficiency are compared among the light emitting elements of Examples 2 to 4 and Comparative Examples 4, 6, 8, 10 and 11 which are same in the value of the ratio r2 (r2 = 0.07) but are different in the value of the ratio r1, the following facts were found out. Namely, regarding the light emitting elements of Examples 2 to 4 and Comparative Examples 4, 6 and 8 in each of which the ratio r1 was within the range: r1 ≤ 0.07, the current efficiencies in the light emitting elements of Comparative Examples 4, 6 and 8, each of which was provided with the semispherical lens but was not provided with the concave-convex structure layer, were 1.92 times, 1.98 times and 1.86 times respectively the current efficiencies in the light emitting elements of Comparative Examples 5, 7 and 9 each of which was provided with none of the semispherical lens and the concave-convex structure layer. In contrast, the current efficiencies in the light emitting elements of Examples 2 to 4 each of which was provided with both of the semispherical lens and the concave-convex structure layer were 2.19 times, 2.13 times and 2.13 times (each exceeding two times) respectively the current efficiencies in the light emitting elements of Comparative Examples 5, 7 and 9. On the other hand, regarding the light emitting elements of Comparative Examples 10 and 11 in each of which the ratio r1 exceeded 0.7, the current efficiency in the light emitting element of Comparative Example 11 which was provided with the semispherical lens but was not provided with the concave-convex structure layer was 1.72 times the current efficiency in the light emitting element of Comparative Example 12 which was provided with none of the semispherical lens and the concave-convex structure layer; whereas the current efficiency in the light emitting element of Comparative Example 10 provided with both of the semispherical lens and the concave-convex structure layer was 1.91 times the current efficiency in the light emitting element of Comparative Example 12. From the above results, it was appreciated that by providing the concave-convex structure layer and the semispherical lens in the optical element such that the ratio r1 is within the range of r1 ≤ 0.7, the current efficiency of the light emitting element was improved not less than two times the current efficiency in the light emitting element provided with none of the concave-convex structure layer and the semispherical lens.

Next, the influence of the value of the ratio r2 on the current efficiency will be analyzed. In a case that the results of calculation of the scale factor of the current efficiency are compared among the light emitting elements of Examples 2, 5 and 6 and Comparative Examples 4, 13, 15, 17, 18, 20 and 21 which are same in the value of the ratio r1 (r1 = 0.30) but are different in the value of the ratio r2, the following facts were found out. Namely, regarding the light emitting elements of Examples 2, 5 and 6 and Comparative Examples 4, 13, 15 in each of which the ratio r2 was within the range: r2 ≤ 0.25, the current efficiencies in the light emitting elements of Comparative Examples 4, 13 and 15, each of which was provided with the semispherical lens but was not provided with the concave-convex structure layer, were 1.92 times, 1.57 times and 1.49 times respectively the current efficiencies in the light emitting elements of Comparative Examples 5, 14 and 16 each of which was provided with none of the semispherical lens and the concave-convex structure layer. In contrast, the current efficiencies in the light emitting elements of Examples 2, 5 and 6 each of which was provided with both of the semispherical lens and the concave-convex structure layer were 2.19 times, 2.03 times and 2.00 times respectively the current efficiencies in the light emitting elements of Comparative Examples 5, 14 and 16. On the other hand, regarding the light emitting elements of Comparative Examples 17, 18, 20 and 21 in each of which the ratio r2 exceeded 0.25, the current efficiencies in the light emitting elements of Comparative Example 18 and 21 each of which was provided with the semispherical lens but not provided with the concave-convex structure layer were 1.39 times and 1.27 times, respectively, the current efficiencies of the light emitting elements of Comparative Examples 19 and 22 each of which was provided with none of the semispherical lens and the concave-convex structure layer; whereas the current efficiencies in the light emitting elements of Comparative Examples 17 and 20 each of which was provided with both of the semispherical lens and the concave-convex structure layer were 1.69 times and 1.58 times, respectively, the current efficiencies in the light emitting elements of Comparative Examples 19 and 22. From the above results, it was appreciated that by providing the concave-convex structure layer and the semispherical lens in the optical element such that the ratio r2 is within the range of r2 ≤ 0.25, the current efficiency of the light emitting element was improved not less than two times the current efficiency in the optical element provided with none of the concave-convex structure layer and the semispherical lens.

From these results, it was appreciated that by providing the concave-convex structure layer and the semispherical lens in the optical element, and when doing so, further by making the ratio r1 (=D2/D1) of the diameter D2 of the light emitting portion to the diameter D1 of the semispherical lens be within the range of r1 $\leq$ 0.7 and by making the ratio r2 (=d/D1) of the distance d, in the Z direction, between the surface of the base member having the lens member adhered thereon and the center of the light emitting portion be within the range of r2 $\leq$ 0.25, the current efficiency of the light emitting element is improved to be not less than two times and a light emitting element having a small chromaticity angle dependency can be obtained.

Although the present invention has been explained as above with the embodiment, the examples, and the comparative examples, the optical element of the present invention is not limited to the above-described embodiment, and may be appropriately modified or changed within the range of the technical ideas described in the following claims. For example, although the light emitting element described in the embodiment is an organic EL element of bottom emission type, the light emitting element of the present invention is not limited to this. For example, the light emitting element of the present invention may be an organic EL element of top emission type.

INDUSTRIAL APPLICABILITY

The light emitting element of the present invention includes the lens member and the concave-convex structure layer functioning as the diffraction grating, and thus has a sufficient light-emitting efficiency; further, in the light emitting element of the present invention, the change in color due to the field angle is small. Since the light emitting element of the present invention has an excellent light emitting property, the light emitting element is quite effective for a various kinds of light emitting devices such as displays, illumination devices, etc., and also contributes to energy conservation.

Reference Sign List:

| | |
|---|---|
| 20 | lens member |
| 40 | base member |
| 92 | first electrode |
| 94 | organic layer |
| 94a | light emitting portion |
| 98 | second electrode |
| 100 | light emitting element |
| 101 | sealing member |
| 142 | concave-convex structure layer |

**Claims**

1. A light emitting element, comprising:

    a concave-convex structure layer, a first electrode, an organic layer, and a second electrode which are provided on a surface of a base member in this order; and
    a lens member arranged on an opposite surface of the base member on a side opposite to the surface,

    wherein a center of the lens member and a center of a light emitting portion are coincident to each other in a plane view, the light emitting portion being an area of the organic layer sandwiched between the first and second electrodes in a thickness direction of the base member;
    a ratio of a diameter D2 of the light emitting portion to a diameter D1 of the lens member satisfies D2/D1 $\leq$ 0.7; and
    a ratio of a distance d to the diameter D1 of the lens member satisfies d/D1 $\leq$ 0.25, the distance d being a distance between the opposite surface of the base member and the center of the light emitting portion.

2. The light emitting element according to claim 1, wherein the lens member is a semispherical lens.

3. The light emitting element according to claim 1 or 2, wherein the concave-convex structure layer is formed of a sol-gel material.

4. The light emitting element according to any one of claims 1 to 3, further comprising a covering layer covering a surface of the concave-convex structure layer and arranged between the concave-convex structure layer and the first electrode.

5. The light emitting element according to any one of claims 1 to 4, wherein the base member is a glass base member.

6. The light emitting element according to any one of claims 1 to 5, wherein refractive index of the lens member is not less than 1.4.

7. The light emitting element according to any one of claims 1 to 6, wherein the concave-convex structure layer has a concave-convex pattern in which an average pitch of concavities and convexities is in a range of 100 nm to 1500 nm, and a standard deviation of depth of the concavities and convexities is in a range of 10 nm to 100 nm.

8. The light emitting element according to any one of claims 1 to 7, wherein the diameter D1 of the lens member is in a range of 1 mm to 100 mm.

9. The light emitting element according to any one of claims 1 to 8, wherein the diameter D2 of the light emitting portion is in a range of 0.5 mm to 70 mm.

10. The light emitting element according to any one of claims 1 to 9, wherein the distance d between the opposite surface of the base member and the center of the light emitting portion is in a range of 0.04 mm to 5 mm.

## Fig. 1

(a)

100

94
98
142
92

X
Z
Y

I
I

100

(b)

D2

98
94a
94
92
142
40

d

20

Z
X
Y

D1

## Fig. 2

(a)

98 94 100

92

142

103

X

Y

Z

(b)

100

101

98

94a

94

103

92

142

40

20

105

103

Z

Y

X

## Fig. 3

FILM-SHAPED MOLD
TRAVELING
DIRECTION

PRESSING
ROLL ROTATING
DIRECTION

50

122

123

42

42

40

SUBSTRATE TRANSPORTING ——→
DIRECTION

## Fig. 4

D2

98
94a
94
92
40
20

d

D1

## Fig. 5

D2

98
94a
94
92
40

d

## Fig. 6

| | Con-cave-convex structure layer | Lens | D1 (mm) | D2 (mm) | d (mm) | r1= D2/D1 | r2= d/D1 | Δc |
|---|---|---|---|---|---|---|---|---|
| Example 1 | Yes | Yes | 10 | 4.2 | 0.7 | 0.42 | 0.07 | <0.012 |
| Comparative Example 1 | No | Yes | 10 | 4.2 | 0.7 | 0.42 | 0.07 | <0.022 |
| Comparative Example 2 | No | No | - | 4.2 | 0.7 | - | - | <0.011 |
| Comparative Example 3 | Yes | Yes | 5 | 4.2 | 0.7 | 0.84 | 0.14 | <0.025 |

# Fig. 7

| | Concave-convex structure layer | Lens | D1 (mm) | D2 (mm) | d (mm) | r1= D2/ D1 | r2= d/ D1 | Current Efficiency (cdA$^{-1}$) | Scale Factor |
|---|---|---|---|---|---|---|---|---|---|
| Example 2 | Yes | Yes | 10 | 3.0 | 0.7 | 0.30 | 0.07 | 159.8 | 2.19 |
| Comparative Example 4 | No | Yes | 10 | 3.0 | 0.7 | 0.30 | 0.07 | 140.1 | 1.92 |
| Comparative Example 5 | No | No | - | 3.0 | 0.7 | - | - | 72.8 | 1.00 |
| Example 3 | Yes | Yes | 10 | 5.2 | 0.7 | 0.52 | 0.07 | 151.3 | 2.13 |
| Comparative Example 6 | No | Yes | 10 | 5.2 | 0.7 | 0.52 | 0.07 | 140.7 | 1.98 |
| Comparative Example 7 | No | No | - | 5.2 | 0.7 | - | - | 70.9 | 1.00 |
| Example 4 | Yes | Yes | 10 | 6.7 | 0.7 | 0.67 | 0.07 | 151.2 | 2.13 |
| Comparative Example 8 | No | Yes | 10 | 6.7 | 0.7 | 0.67 | 0.07 | 132.3 | 1.86 |
| Comparative Example 9 | No | No | - | 6.7 | 0.7 | - | - | 71.1 | 1.00 |
| Comparative Example 10 | Yes | Yes | 10 | 7.9 | 0.7 | 0.79 | 0.07 | 133.4 | 1.91 |
| Comparative Example 11 | No | Yes | 10 | 7.9 | 0.7 | 0.79 | 0.07 | 120.5 | 1.72 |
| Comparative Example 12 | No | No | - | 7.9 | 0.7 | - | - | 70.0 | 1.00 |
| Example 5 | Yes | Yes | 10 | 3.0 | 1.4 | 0.30 | 0.14 | 152.3 | 2.03 |
| Comparative Example 13 | No | Yes | 10 | 3.0 | 1.4 | 0.30 | 0.14 | 118.2 | 1.57 |
| Comparative Example 14 | No | No | - | 3.0 | 1.4 | - | - | 75.1 | 1.00 |
| Example 6 | Yes | Yes | 10 | 3.0 | 2.1 | 0.30 | 0.21 | 147.3 | 2.00 |
| Comparative Example 15 | No | Yes | 10 | 3.0 | 2.1 | 0.30 | 0.21 | 110.2 | 1.49 |
| Comparative Example 16 | No | No | - | 3.0 | 2.1 | - | - | 74.2 | 1.00 |
| Comparative Example 17 | Yes | Yes | 10 | 3.0 | 2.8 | 0.30 | 0.28 | 127.3 | 1.69 |
| Comparative Example 18 | No | Yes | 10 | 3.0 | 2.8 | 0.30 | 0.28 | 105.2 | 1.39 |
| Comparative Example 19 | No | No | - | 3.0 | 2.8 | - | - | 75.4 | 1.00 |
| Comparative Example 20 | Yes | Yes | 10 | 3.0 | 3.5 | 0.30 | 0.35 | 118.6 | 1.58 |
| Comparative Example 21 | No | Yes | 10 | 3.0 | 3.5 | 0.30 | 0.35 | 95.4 | 1.27 |
| Comparative Example 22 | No | No | - | 3.0 | 3.5 | - | - | 75.1 | 1.00 |

Fig. 8

(a)

(b)

Fig. 9

(a)

(b)

## INTERNATIONAL SEARCH REPORT

| International application No. |
| --- |
| PCT/JP2014/081182 |

A. CLASSIFICATION OF SUBJECT MATTER

*H05B33/02*(2006.01)i, *H01L51/50*(2006.01)i, *H05B33/22*(2006.01)i

According to International Patent Classification (IPC) or to both national classification and IPC

B. FIELDS SEARCHED

Minimum documentation searched (classification system followed by classification symbols)

H05B33/02, H01L51/50, H05B33/22

Documentation searched other than minimum documentation to the extent that such documents are included in the fields searched

| Jitsuyo Shinan Koho | 1922–1996 | Jitsuyo Shinan Toroku Koho | 1996–2015 |
| Kokai Jitsuyo Shinan Koho | 1971–2015 | Toroku Jitsuyo Shinan Koho | 1994–2015 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2008-117735 A (Toppan Printing Co., Ltd.), 22 May 2008 (22.05.2008), claim 1; paragraphs [0002], [0074], [0170] to [0198]; fig. 7 (Family: none) | 1-10 |
| Y | JP 2008-98083 A (Toppan Printing Co., Ltd.), 24 April 2008 (24.04.2008), claim 1; paragraphs [0002], [0115] to [0134]; fig. 5 (Family: none) | 1-10 |
| Y | JP 2011-71012 A (Fujifilm Corp.), 07 April 2011 (07.04.2011), claim 1; paragraphs [0045], [0051], [0076]; fig. 8 (Family: none) | 1-10 |

☒ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 14 January 2015 (14.01.15) | 03 February 2015 (03.02.15) |

| Name and mailing address of the ISA/ | Authorized officer |
| --- | --- |
| Japan Patent Office 3-4-3,Kasumigaseki,Chiyoda-ku, Tokyo 100-8915,Japan | |
| | Telephone No. |

Form PCT/ISA/210 (second sheet) (July 2009)

**INTERNATIONAL SEARCH REPORT**

International application No.

PCT/JP2014/081182

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2003-31353 A (Matsushita Electric Industrial Co., Ltd.), 31 January 2003 (31.01.2003), claim 4; paragraphs [0018], [0035]; fig. 4 (Family: none) | 1-10 |
| Y | JP 2011-54526 A (Fujifilm Corp.), 17 March 2011 (17.03.2011), claim 6; paragraphs [0059] to [0064]; fig. 4 & US 2011/0057221 A1 | 1-10 |
| Y | WO 2013/187149 A1 (JX Nippon Oil & Energy Corp.), 19 December 2013 (19.12.2013), paragraph [0022]; claims 1, 11 & TW 201407848 A | 3,7 |
| Y | WO 2013/161454 A1 (JX Nippon Oil & Energy Corp.), 31 October 2013 (31.10.2013), paragraph [0014]; claim 15; fig. 2 & TW 201402297 A | 3,7 |
| A | JP 2008-66027 A (Fuji Electric Holdings Co., Ltd.), 21 March 2008 (21.03.2008), claim 6; paragraph [0050]; fig. 5 (Family: none) | 1-10 |
| A | JP 2011-60720 A (Fujifilm Corp.), 24 March 2011 (24.03.2011), claim 2; fig. 4a (Family: none) | 1-10 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011054407 A
- WO 2012147759 A
- JP H8112879 B
- JP 5238827 A
- JP 6122852 A
- JP 6240208 A
- JP 6299118 A
- JP 6306329 A
- JP 7196986 A
- WO 2012096368 A
- WO 2013161454 A
- WO 2011007878 A1

**Non-patent literature cited in the description**

- Kagaku Binran Ouyou Hen'' (Handbook of Chemistry, Applied Chemistry)